(19) Europäisches Patentamt
European Patent Office
Office européen des brevets

(11) EP 1 630 217 A1

(12) EUROPEAN PATENT APPLICATION
published in accordance with Art. 158(3) EPC

(43) Date of publication:
**01.03.2006 Bulletin 2006/09**

(21) Application number: **04729268.5**

(22) Date of filing: **23.04.2004**

(51) Int Cl.:
***C09K 11/06** (1974.07)* ***H05B 33/14** (1968.09)*

(86) International application number:
**PCT/JP2004/005941**

(87) International publication number:
**WO 2004/096946 (11.11.2004 Gazette 2004/46)**

(84) Designated Contracting States:
**DE GB**

(30) Priority: **30.04.2003 JP 2003124882**

(71) Applicants:
- **Takasago International Corporation Tokyo 144-8721 (JP)**
- **NIPPON HOSO KYOKAI Tokyo 150-8001 (JP)**

(72) Inventors:
- **NAKAYAMA, Yuji, Takasago International Corporation Hiratsuka-shi, Kanagawa 2540073 (JP)**
- **IWATA, Takeshi, Takasago International Corporation Hiratsuka-shi, Kanagawa 2540073 (JP)**
- **MATSUSHIMA, Y., Takasago International Corporation Hiratsuka-shi, Kanagawa 2540073 (JP)**
- **HORI, Yoji, Takasago International Corporation Hiratsuka-shi, Kanagawa 2540073 (JP)**
- **TOKITO, Shizuo, Nippon Hoso Kyokai Setagaya-ku, Tokyo 1578510 (JP)**
- **TSUZUKI, Toshimitsu, Nippon Hoso Kyokai Setagaya-ku, Tokyo 1578510 (JP)**

(74) Representative: **Neidl-Stippler, Cornelia Patentanwälte Neidl-Stippler & Partner, Rauchstrasse 2 D-81679 München (DE)**

# (54) LIGHT-EMITTING DEVICE

(57) A light-emitting device such as an organic electroluminescent device is disclosed wherein a platinum complex represented by the following general formula:

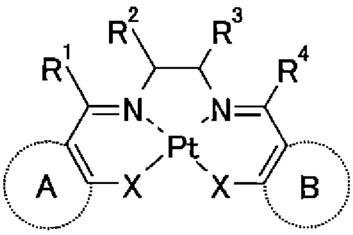

(wherein, rings A and B each independently represent an aromatic ring optionally having substituent (s) or an aromatic heterocyclic ring optionally having substituent (s) ; X represents an oxygen atom or a sulfur atom; $R^1$, $R^2$, $R^3$and $R^4$ each independently represent a hydrogen atom or a substituent; and more, $R^1$ and $R^2$, $R^2$ and $R^3$, and $R^3$ and $R^4$ may respectively combine together to form a fused ring.) is used as a light-emitting layer material, a charge transporting material or the like.

EP 1 630 217 A1

Fig. 1

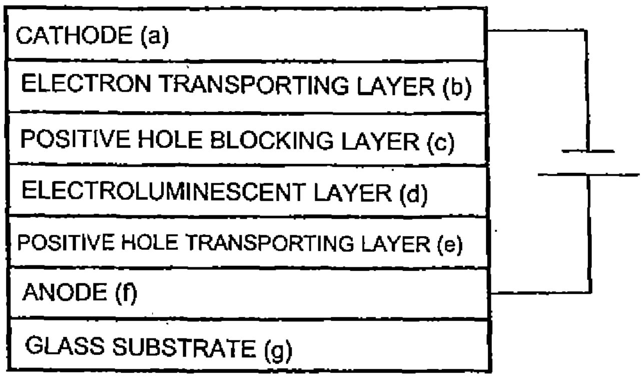
CATHODE (a)
ELECTRON TRANSPORTING LAYER (b)
POSITIVE HOLE BLOCKING LAYER (c)
ELECTROLUMINESCENT LAYER (d)
POSITIVE HOLE TRANSPORTING LAYER (e)
ANODE (f)
GLASS SUBSTRATE (g)

**Description**

TECHNICAL FIELD

The present invention relates to a light-emitting device containing new platinum complex(es), in particular to a light-emitting device that can be used favorably as a display device, a back light unit, an exposure light source of an electrophotographic machine, an illumination light source, a record light source, a light-exposure source, a read light source, signs and marks, a signboard, interior goods, or the like.

BACKGROUND ART

Various research and development of display devices have been eagerly conducted recently, and among them, organic electroluminescent devices (hereinafter, referred to as "organic EL devices") capable of emitting high-brightness light at low voltage are attracting attention as a promising next-generation display device. The organic EL device is faster in response than the liquid crystal device traditionally used as a display device. In addition, because of self-emitting the organic EL device does not need back light units as in the liquid crystal display device, and allows production of an extremely thinner flat panel display. The organic EL device, that is a light-emitting device utilizing an electroluminescence (EL) phenomenon, is similar in principle to LEDs, and is characteristic in that it uses organic compounds as its light-emitting materials. As an example of the organic EL device using such an organic compound as the light-emitting material, there were reported organic EL devices utilizing multilayer thin films formed by evaporative deposition. The light-emitting device, which has deposited layers of a tris(8-hydroxyquinolinato-O,N)aluminum ($Alq_3$) as electron transporting material and a hole transporting material (e.g., aromatic amine compound), is significantly improved in emission characteristics, compared with conventional single-layer devices.

It is necessary, for development of a high-performance multi-colored display, to improve the properties and efficiency of the light-emitting devices respectively in the three primary colors of light, red, green and blue. Use of a phosphorescent material in the light-emitting layer was also proposed as a means of improving the properties of the organic EL device. Phosphorescence is a light emission phenomenon from a triplet excited state, and is known to show a quantum efficiency higher than that of the fluorescence, that is a light emission phenomenon from a singlet excited state. It would be possible to achieve a high luminous efficiency by using organic compounds having such properties as light-emitting materials.

As such an organic EL device using the phosphorescent substance, a device using an orthometalated iridium complex, tris(2-phenylpyridinato-N,$C^{2'}$)iridium (III), in the light-emitting layer was already reported. The report discloses that the iridium complex is a green phosphorescent substance higher in color purity that has an extremely favorable external quantum efficiency of 9%. However, there are still no red or blue phosphorescent substance superior both in color purity and luminous efficiency. For example, a device using a platinum complex, (2,3,7,8,12,13,17,18-octaethyl-21H,23H-porphinato-N,N,N,N)platinum (II) [Pt(OEP)] in a light-emitting layer is reported as the organic EL device using a red phosphorescent material (e.g., M. A. Baldoetal., Nature, Vol. 395, 151-154 (1998)). The platinum complex is a red phosphorescent substance higher in color purity, but the external quantum efficiency is still approximately 4% as determined by the measuring method described in the literature, demanding further improvement in luminous efficiency. More recently, a device using bis[2-(2'-benzothienyl)pyridinato-N,$C^{3'}$]iridium (III) acetylacetonate [$Ir(btp)_2(acac)$] in the light-emitting layer has been reported. This platinum complex has a relatively favorable external quantum efficiency of approximately 7%, but is far lower in color purity than Pt(OEP).

On the other hand, as a platinum complex, [[2,2'-[1,2-phenylenebis(nitrilomethylidyne)]bis[phenolate]]-N,N',O,O']platinum (II) has been known and phenomena of UV light absorption and fluorescence thereof have been reported (e.g., M. E. Ivanova et al., Zhur. Fiz. Khim., Vol.65, 2957-2964 (1991)).

However, there was no report on application of the compound to light-emitting devices, synthesis of the derivatives obtained by substitutive modification of the ring in the ligand by substituent(s), structural modification of the ring itself, or the like. In addition, even though the compound shows such phenomena of UV light absorption and fluorescence, it is not clear whether the compound or the derivative thereof shows such a phosphorescence phenomenon when used in organic EL devices, or whether it shows properties better than those of the devices currently used.

As described above, various studies for making next-generation display devices fit for practical use are being conducted. Among these, organic EL devices using a phosphorescent material are spotlighted particularly from the viewpoint of improvement in properties. However, the research has been started only recently, and there are still many problems pending, for example, of improvement in the light-emission characteristics, luminous efficiency, and color purity of the device and optimization of its structure. To solve the problems above, it is desired to develop new phosphorescent materials and methods of supplying the material efficiently.

An object of the present invention, which was made considering the problems above, is to provide a light-emitting device utilized in many fields and having superior light-emission characteristics and superior luminous efficiency.

DISCLOSURE OF THE INVENTION

As a result of eager study and examination to solve the problems above, the present inventors have found that light-emitting devicesproduced by using platinum complexeshaving a specific structure shows superior light-emission characteristics and superior luminous efficiency, and the present invention is completed on the basis of the finding.

Accordingly, the present invention relates to a light-emitting device containing one or more of platinum complexes represented by general formula (1):

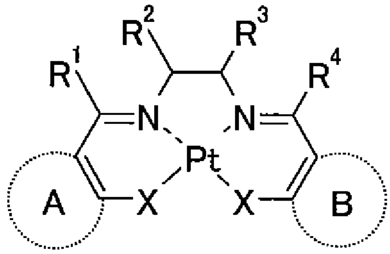

wherein, rings A and B each independently represent an aromatic ring optionally having substituent (s) or an aromatic heterocyclic ring optionally having substituent (s) ; X represents an oxygen atom or a sulfur atom; $R^1$, $R^2$, $R^3$and $R^4$ each independently represent a hydrogen atom or a substituent; and more, $R^1$ and $R^2$, $R^2$ and $R^3$, and $R^3$ and $R^4$ may respectively combined together to form a fused ring.

BRIEF DESCRIPTION OF THE DRAWING

Fig. 1 is a schematic sectional view illustrating the layer structure of an organic EL device.

DETAILED DESCRIPTION OF THE INVENTION

Hereinafter, the platinum complexes used in the light-emitting device of the present invention represented by the general formula (1) will be described in more detail.

In the general formula (1), rings A and B each independently represent an aromatic ring optionally having substituent(s) or an aromatic heterocyclic ring optionally having substituent (s) . The aromatic ring includes, for example, an aromatic ring which is a monocyclic, polycyclic or fused ring having 6 to 14 carbons, and specific examples thereof include benzene, naphthalene, anthracene, and phenanthrene rings, and the like. The substituted aromatic ring includes the abovementioned aromatic rings of which at least one hydrogen atom is substituted with a substituent.

The aromatic heterocyclic ring includes an aromatic heterocyclic ring of, for example, a five- to eight-membered, preferably five- or six-membered monocyclic, polycyclic or fused ring, having 2 to 15 carbon atoms and one or more, preferably one to three heteroatoms such as a nitrogen atom, an oxygen atom, and a sulfur atom. And specific examples thereof include furan, thiophene, pyridine, pyrimidine, pyrazine, pyridazine, pyrazoline, imidazole, oxazole, thiazole, benzofuran, benzothiophene, quinoline, isoquinoline, quinoxaline, phthalazine, quinazoline, naphthyridine, cinnoline, benzimidazole, benzoxazole, and benzothiazole rings, and the like. The substituted aromatic heterocyclic ring includes a substituted aromatic heterocyclic ring in which at least one hydrogen atom of the aromatic heterocyclic ring above is substituted with a substituent.

Examples of the substituent above include a hydrocarbyl group, an aliphatic heterocyclic group, an aromatic heterocyclic group, a hydroxyl group, an alkoxy group, an alkylenedioxy group, an aryloxy group, an aralkyloxy group, a heteroaryloxy group, an acyloxy group, an acyl group, a carboxyl group, an alkoxycarbonyl group, an aryloxycarbonyl group, an aralkyloxycarbonyl group, a mercapto group, an alkylthio group, an arylthio group, an aralkylthio group, a heteroarylthio group, a sulfino group, a sulfinyl group, a sulfo group, a sulfonyl group, an amino group, a substituted amino group, a carbamoyl group, a substituted carbamoyl group, a sulfamoyl group, a substituted sulfamoyl group, an ureido group, a substituted ureido group, a phosphoric amide group, a silyl group, a hydrazino group, a cyano group, a nitro group, a hydroxamic acid group, a halogen atom, and the like.

More specifically, typical examples of the hydrocarbyl group include an alkyl group, an alkenyl group, an alkynyl group, an aryl group, an aralkyl group, and the like. Among these groups, the alkyl group may be a straight-chain,

branched, or cyclic alkyl group having, for example, 1 to 15 carbon atoms, preferably 1 to 10 carbon atoms, and more preferably 1 to 6 carbons; and specific examples thereof include methyl, ethyl, n-propyl, 2-propyl, n-butyl, 2-butyl, isobutyl, tert-butyl, n-pentyl, 2-pentyl, tert-pentyl, 2-methylbutyl, 3-methylbutyl, 2,2-dimethylpropyl, n-hexyl, 2-hexyl, 3-hexyl, tert-hexyl, 2-methylpentyl, 3-methylpentyl, 4-methylpentyl, 2-methylpentan-3-yl, cyclopropyl, cyclobutyl, cyclopentyl, and cyclohexyl groups, and the like. The alkenyl group includes a straight-chain or branched alkenyl group having, for example, 2 to 15 carbon atoms, preferably 2 to 10 carbon atoms, and more preferably having 2 to 6 carbons; and specific examples thereof include ethenyl, propenyl, 1-butenyl, pentenyl, and hexenyl groups, and the like. The alkynyl group includes a straight-chain or branched alkynyl group having, for example, 2 to 15 carbon atoms, preferably 2 to 10 carbon atoms, and more preferably 2 to 6 carbons; and specific examples thereof include ethynyl, 1-propynyl, 2-propynyl, 1-butynyl, 3-butynyl, pentynyl, and hexynyl groups, and the like. Thearylgroupincludes an aryl group having, for example, 6 to 14 carbons; and specific examples thereof include phenyl, naphthyl, anthryl, phenanthrenyl, and biphenyl groups, and the like. The aralkyl group includes an aralkyl group in which at least one hydrogen atom of the alkyl group above is substituted with the aryl group above and preferable are aralkyl groups having, for example, 7 to 13 carbons. And specific examples thereof include benzyl, 2-phenylethyl, 1-phenylpropyl, and 3-naphthylpropyl groups, and the like.

The aliphatic heterocyclic group includes, for example, a five- to eight-membered, preferably five- or six-membered monocyclic, polycyclic, or fused ring aliphatic heterocyclic group, having 2 to 14 carbon atoms and having one or more, preferably one to three, heteroatoms such as a nitrogen atom, an oxygen atom, and a sulfur atom. Typical examples of the aliphatic heterocyclic group include pyrrolidyl-2-one, piperidino, piperadinyl, morpholino, tetrahydrofuryl, tetrahydropyranyl, and tetrahydrothienyl groups, and the like.

Further, the aromatic heterocyclic group is, for example, a five- to eight-membered, preferably five- or six-membered monocyclic, polycyclic or fused ring heteroaryl group having 2 to 15 carbon atoms and having one or more, preferably one to three, heteroatoms such as a nitrogen atom, an oxygen atom, and a sulfur atom; and specific examples thereof include furyl, thienyl, pyridyl, pyrimidyl, pyrazyl, pyridazyl, pyrazolyl, imidazolyl, oxazolyl, thiazolyl, benzofuryl, benzothienyl, quinolyl, isoquinolyl, quinoxalyl, phthalazyl, quinazolyl, naphthyridyl, cinnolyl, benzimidazolyl, benzoxazolyl, and benzothiazolyl groups, and the like.

The alkoxy group includes a straight-chain, branched, or cyclic alkoxy group having, for example, 1 to 6 carbons; and specific examples thereof include methoxy, ethoxy, n-propoxy, 2-propoxy, n-butoxy, 2-butoxy, isobutoxy, tert-butoxy, n-pentyloxy, 2-methylbutoxy, 3-methylbutoxy, 2,2-dimethylpropyloxy, n-hexyloxy, 2-methylpentyloxy, 3-methylpentyloxy, 4-methylpentyloxy, 5-methylpentyloxy, and cyclohexyloxy groups, and the like.

The alkylenedioxy group includes an alkylenedioxy group having, for example, 1 to 3 carbons; and specific examples thereof include methylenedioxy, ethylenedioxy, and propylenedioxy groups, and the like.

The aryloxy group includes an aryloxy group having, for example, 6 to 14 carbons, and specific examples thereof include phenyloxy, naphthyloxy, and anthryloxy groups, and the like.

The aralkyloxy group includes an aralkyloxy group having, for example, 7 to 12 carbons, and specific examples thereof include benzyloxy, 2-phenylethoxy, 1-phenylpropoxy, 2-phenylpropoxy, 3-phenylpropoxy, 1-phenylbutoxy, 2-phenylbutoxy, 3-phenylbutoxy, 4-phenylbutoxy, 1-phenylpentyloxy, 2-phenylpentyloxy, 3-phenylpentyloxy, 4-phenylpentyloxy, 5-phenylpentyloxy, 1-phenylhexyloxy, 2-phenylhexyloxy, 3-phenylhexyloxy, 4-phenylhexyloxy, 5-phenylhexyloxy, and 6-phenylhexyloxy groups, and the like.

The heteroaryloxy group includes, for example, a heteroaryloxy group having 2 to 14 carbons and having one or more, preferably one to three, heteroatom(s) such as a nitrogen atom, an oxygen atom, and a sulfur atom; and specific examples thereof include 2-pyridyloxy, 2-pyrazyloxy, 2-pyrimidyloxy, and 2-quinolyloxy groups and the like.

The acyloxy group includes, for example, a carboxylic acid-derived acyloxy group having 2 to 18 carbons; and specific examples thereof include acetoxy, propionyloxy, butyryloxy, pivaloyloxy, pentanoyloxy, haxanoyloxy, lauroyloxy, stearoyloxy, and benzoyloxy groups, and the like.

The acyl group includes, for example, a straight-chain or branched acyl group having 1 to 18 carbon atoms derived from a fatty or aromatic carboxylic acid; and specific examples thereof include formyl, acetyl, propionyl, butyryl, pivaloyl, pentanoyl, haxanoyl, lauroyl, stearoyl, and benzoyl groups, and the like.

The alkoxycarbonyl group includes a straight-chain, branched, or cyclic alkoxycarbonyl group having, for example, 2 to 19 carbon atoms; and specific examples thereof include methoxycarbonyl, ethoxycarbonyl, n-propoxycarbonyl, 2-propoxycarbonyl, n-butoxycarbonyl, tert-butoxycarbonyl, pentyloxycarbonyl, hexyloxycarbonyl, 2-ethylhexyloxycarbonyl, lauryloxycarbonyl, stearyloxycarbonyl, and cyclohexyloxycarbonyl groups, and the like.

The aryloxycarbonyl group includes an aryloxycarbonyl group having, for example, 7 to 20 carbon atoms; and specific examples thereof include phenoxycarbonyl and naphthyloxycarbonyl groups, and the like. The aralkyloxycarbonyl group includes an aralkyloxycarbonyl group having, for example, 8 to 15 carbon atoms; and specific examples thereof include benzyloxycarbonyl, phenylethoxycarbonyl, and 9-fluorenylmethyloxycarbonyl groups, and the like.

The alkylthio group includes a straight-chain, branched, or cyclic alkylthio group having, for example, 1 to 6 carbon atoms; and specific examples thereof include methylthio, ethylthio, n-propylthio, 2-propylthio, n-butylthio, 2-butylthio, isobutylthio, tert-butylthio, pentylthio, hexylthio, and cyclohexylthio groups, and the like. The arylthio group

includes arylthio groups having, for example, 6 to 14 carbons, such as a phenylthio or naphthylthio group. The aralkylthio group includes an aralkylthio group having, for example, 7 to 12 carbons, such as a benzylthio or 2-phenethylthio group. The heteroarylthio group is, for example, heteroarylthio groups having 2 to 14 carbons and having one or more, preferably one to three, heteroatoms such as a nitrogen atom, an oxygen atom, and a sulfur atom; and specific examples thereof include 4-pyridylthio, 2-benzimidazolylthio, 2-benzoxazolylthio, and 2-benzothiazolylthio groups, and the like.

The sulfinyl group includes a substituted sulfinyl group represented by, for example, R-SO- (R represents one of the alkyl, aryl, and aralkyl groups above, or the like.). Typical examples of the sulfinyl group include methanesulfinyl and benzenesulfinyl groups, and the like. The sulfonyl group includes a substituted sulfonyl group represented by, for example, R-$SO_2$- (R represents one of the alkyl, aryl, and aralkyl groups above or the like.). Typical examples of the sulfonyl group include methanesulfonyl and p-toluenesulfonyl groups, and the like.

The substituted amino group includes, for example, a substituted amino group in which one or two hydrogen atoms of an amino group are substituted with substituent (s) such as the alkyl and aryl groups above or an amino group-protecting group. The protecting group is not particularly limited if it is used as an amino protecting group, and examples thereof include the amino protecting groups described in PROTECTIVE GROUPS IN ORGANIC SYNTHESIS, Second Edition, John Wiley & Sons, Inc. Typical examples of the amino protecting group include an aralkyl group, an acyl group, an alkoxycarbonyl group, an aryloxycarbonyl group, an aralkyloxycarbonyl group, a sulfonyl group, and the like.

Typical examples of the amino group substituted with alkyl group(s), i.e., an alkyl group-substituted amino group, include mono- or di-alkylamino groups such as N-methylamino, N,N-dimethylamino, N,N-diethylamino, N,N-diisopropylamino, and N-cyclohexylamino groups, and the like. Typical examples of the amino group substituted with aryl group(s), i.e., an aryl group-substituted amino group, include mono- or di-arylamino groupssuch as N-phenylamino, N, N-diphenylamino, N-naphthylamino, and N-naphthyl-N-phenylamino groups, and the like. Typical examples of the amino group substituted with aralkyl group(s), i.e., an aralkyl group-substituted amino group include mono- or di-aralkylamino groups such as N-benzylamino and N,N-dibenzylamino groups, and the like.

Typical examples of the amino group substituted with an acyl group, i.e., an acylamino group, include formylamino, acetylamino, propionylamino, pivaloylamino, pentanoylamino, hexanoylamino, and benzoylamino groups, and the like. Typical examples of the amino group substituted with an alkoxycarbonyl group, i.e., an alkoxycarbonylamino group, include methoxycarbonylamino, ethoxycarbonylamino, n-propoxycarbonylamino, n-butoxycarbonylamino, tert-butoxycarbonylamino, pentyloxycarbonylamino, and hexyloxycarbonylamino groups, and the like. Typical examples of the amino group substituted with an aryloxycarbonyl group, i.e., an aryloxycarbonylamino group, include phenoxycarbonylamino and naphthyloxycarbonylamino groups, and the like. Typical examples of the amino group substituted with an aralkyloxycarbonyl group, i.e., an aralkyloxycarbonylamino group, include a benzyloxycarbonylamino group and the like. Typical examples of the amino group substituted with a sulfonyl group, i.e., a sulfonylamino group, include methanesulfonylamino and p-toluenesulfonylamino groups, and the like.

Examples of the substituted carbamoyl group include a substituted carbamoyl group in which one or two hydrogen atoms of an amino group in a carbamoyl group are substituted with substituent (s) such as the alkyl, aryl, and aralkyl groups above; and specific examples thereof include N-methylcarbamoyl, N,N-diethylcarbamoyl, and N-phenylcarbamoyl groups, and the like. Examples of the substituted sulfamoyl group include a substituted sulfamoyl group in which one or two hydrogen atoms of an amino group in a sulfamoyl group are substituted with substituent(s) such as the alkyl, aryl, and aralkyl groups above; and specific examples thereof include N-methylsulfamoyl, N,N-dimethylsulfamoyl, and N-phenylsulfamoyl groups, and the like. Examples of the substituted ureido group include a substituted ureido group in which at least one hydrogen atom bound to a nitrogen atom of an ureido group is substituted with a substituent such as the alkyl, aryl, and aralkyl groups above; and specific examples thereof include N-methylureido and N-phenylureido groups, and the like.

Examples of the phosphoric amide group include a substituted phosphoric amide group in which one or more hydrogen atoms of a phosphate group are substituted with substituent(s) such as the alkyl, aryl, and aralkyl groups; and specific examples thereof include diethylphosphoric amide and phenylphosphoric amide groups, and the like. Examples of the silyl group include, for example, tri-substituted silyl groups having a silicon atom of which three hydrogen atoms are substituted with substituents such as the alkyl, aryl, and aralkyl groups above; and specific examples thereof include trimethylsilyl, tert-butyldimethylsilyl, tert-butyldiphenylsilyl, and triphenylsilyl groups, and the like. Examples of the halogen atom include a fluorine atom, a chlorine atom, a bromine atom, and an iodine atom.

Among these substituents, the hydrocarbyl, aliphatic heterocyclic, aromatic heterocyclic, alkoxy, alkylenedioxy, aryloxy, aralkyloxy, heteroaryloxy, acyloxy, acyl, alkoxycarbonyl, aryloxycarbonyl, aralkyloxycarbonyl, alkylthio, arylthio, aralkylthio, heteroarylthio, sulfinyl, sulfonyl, substituted amino, substituted carbamoyl, substituted sulfamoyl, substituted ureido, phosphoric amide or silyl group may be substituted additionally with substituent(s) selected from the group of the substituents above.

In the general formula (1), X represents an oxygen atom or a sulfur atom, and particularly preferable example of X is an oxygen atom.

In the general formula (1), $R^1$ and $R^4$ each independently represent a hydrogen atom or a substituent. The substituent includes, for example, a hydrocarbyl group, an aliphatic heterocyclic group, an aromatic heterocyclic group, and the like. Examples of the hydrocarbyl, aliphatic heterocyclic and aromatic heterocyclic groups include those described in detail in the description of the substituents for the rings A and B. These substituents may additionally be substituted with substituent (s) selected from the group of the substituents described in detail in the description for the rings A and B.

In the general formula (1), $R^2$ and $R^3$ each independently represent a hydrogen atom or a substituent. Examples of the substituent include a hydrocarbyl group, an aliphatic heterocyclic group, an aromatic heterocyclic group, an acyl group, a carboxyl group, an alkoxycarbonyl group, an aryloxycarbonyl group, an aralkyloxycarbonyl group, a carbamoyl group, a substituted carbamoyl group, a cyano group, and the like. Examples of the hydrocarbyl, aliphatic heterocyclic, aromatic heterocyclic, acyl, carboxyl, alkoxycarbonyl, aryloxycarbonyl, aralkyloxycarbonyl, carbamoyl, substituted carbamoyl and cyano groups include the substituents described in detail in the description for the rings A and B. In addition, the hydrocarbyl, aliphatic heterocyclic, aromatic heterocyclic, acyl, alkoxycarbonyl, aryloxycarbonyl, aralkyloxycarbonyl, or substituted carbamoyl group may be additionally substituted with substituent(s) selected from the group of the substituents described in detail in the description for rings A and B.

Further, $R^1$ and $R^2$, $R^2$ and $R^3$, and $R^3$ and $R^4$ may respectively combine together to form a ring. Examples of the ring formed by combining of $R^1$ and $R^2$ or $R^3$ and $R^4$ include a nitrogen-containing aromatic heterocyclic ring optionally having substituent(s). Examples of the nitrogen-containing aromatic heterocyclic ring optionally having substituent(s) include a nitrogen-containing aromatic heterocyclic ring and a sustituted nitrogen-containing aromatic heterocyclic ring.

The nitrogen-containing aromatic heterocyclic ring is, for example, an aromatic heterocyclic ring having 2 to 15 carbon atoms and one or more nitrogen atoms capable of coordinating to platinum. The nitrogen-containing aromatic heterocyclic ring may additionally have one to three heteroatom(s) such as a nitrogen atom, an oxygen atom, and a sulfur atom. In addition, two atoms next to the nitrogen atom coordinating to the platinum are preferably carbon atoms. Further, the nitrogen-containing aromatic heterocyclic ring is a five- to eight-membered, preferably five- or six-membered, monocyclic nitrogen-containing aromatic heterocyclic ring, or a nitrogen-containing polycyclic ring or fused aromatic heterocyclic ring. Typical examples of the nitrogen-containing aromatic heterocyclic ring include pyridine, pyrimidine, pyrazine, imidazole, oxazole, thiazole, isoquinoline, quinazoline, and naphthyridine rings, and the like. The substituted nitrogen-containing aromatic heterocyclic ring is, for example, a nitrogen-containing aromatic heterocyclic ring of which one or more hydrogen atoms are substituted with substituent(s). Examples of the substituent include those described in detail in the description of the substituents for the rings A and B.

Examples of the rings formed by combining of $R^2$ and $R^3$ include aliphatic rings optionally having substituent (s), aliphatic heterocyclic rings optionally having substituent(s), aromatic rings optionally having substituent (s), and aromatic heterocyclic rings optionally having substituent(s). Examples of the aliphatic ring optionally having substituent (s) include aliphatic rings and substituted aliphatic rings. Examples of the aliphatic ring include three- to eight-membered monocyclic, polycyclic or fused ring aliphatic rings having 3 to 14 carbon atoms. Typical examples of the aliphatic ring include cyclopropane, cyclobutane, cyclopentane, cyclohexane, and decaline rings, and the like. Typical examples of the substituted aliphatic ring include substituted aliphatic rings in which at least one hydrogen atom of the aliphatic rings described above is substituted with a substituent. Examples of the substituent include the substituents described in detail in the description for rings A and B.

The aliphatic heterocyclic rings optionally having substituent(s) include an aliphatic heterocyclic ring and a substituted aliphatic heterocyclic ring. Examples of the aliphatic heterocyclic ring include a five- to eight-membered, preferably a five- or six-membered monocyclic, polycyclic or fused ring aliphatic heterocyclic rings, having 2 to 14 carbon atoms and one or more, preferably one to three heteroatoms such as a nitrogen atom, an oxygen atom, and a sulfur atom. Typical examples of the aliphatic heterocyclic ring include pyrrolidin-2-one, piperidine, piperazine, morpholine, tetrahydrofuran, tetrahydropyran, and tetrahydrothiophene rings, and the like. The substituted aliphatic heterocyclic ring includes a substituted aliphatic heterocyclic ring in which at least one hydrogen atom of an aliphatic heterocyclic ring is substituted with a substituent. Examples of the substituent include the substituents described in detail in the description for the rings A and B.

Examples of the aromatic ring optionally having substituent(s) and the aromatic heterocyclic ring optionally having substituent(s) include the aromatic or the aromatic heterocyclic ring optionally having substituent (s) described in detail in the description for the rings A and B.

The rings formed by combining of $R^1$ and $R^2$, $R^2$ and $R^3$, or $R^3$ and $R^4$ may additionally combine together to form a fused ring. Typical examples of the fused ring include quinoline, dihydroquinoline, quinazoline, quinoxaline, naphthyridine, 1,10-phenathroline, and 4,5-diazafluoren-9-one rings and the like.

Favorable examples of the platinum complexes represented by the general formula (1) include the platinum complexes represented by general formula (1a):

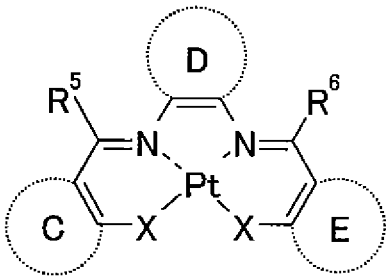

and general formula (1b):

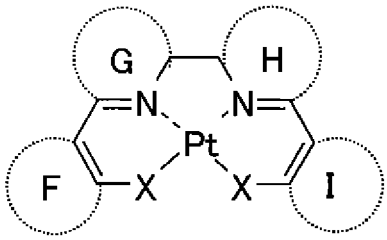

wherein, rings C, D, E, F and I each independently represent an aromatic ring optionally having substituent (s) ; rings G and H each independently represent an aromatic heterocyclic ring optionally having substituent(s); X represents an oxygen atom or a sulfur atom; and $R^5$ and $R^6$ each independently represent a hydrogen atom or a substituent; and more, $R^5$ and ring D, $R^6$ and ring D, or ring G and ring H may combine together to form a fused ring.

As described above, in the general formulae (1a) and (1b), rings C, D, E, F and I each independently represent an aromatic ring optionally having substituent(s). Examples of the aromatic ring optionally having substituent (s) include the aromatic rings optionally having substituent(s) described in detail in the description for the rings A and B. Rings G and H each independently represent a nitrogen-containing aromatic heterocyclic ring optionally having substituent(s). Examples of the nitrogen-containing aromatic heterocyclic ring optionally having substituent(s) include the nitrogen-containing aromatic heterocyclic rings optionally having substituent(s), described in detail in the description for the rings formed by combining of $R^1$ and $R^2$, or $R^3$ and $R^4$. In the formulae, X represents an oxygen atom or a sulfur atom, and particularly preferable example of X is an oxygen atom. $R^5$ and $R^6$ each independently represent a hydrogen atom or a substituent; and examples of the substituent include the substituents described in detail in the description for $R^1$ and $R^4$. Examples of the fused rings formed by combining of $R^5$ and ring D, $R^6$ and ring D, or ring G and ring H include the rings described in detail in the description for the fused rings formed by combining of $R^1$ and $R^2$, $R^2$ and $R^3$, or $R^3$ and $R^4$.

Typical examples of the platinum complexes represented by the general formula (1) of the invention include the compounds represented by the following formulae (1-1) to (1-96).

(1-1)

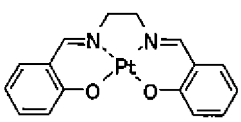

(1-2)

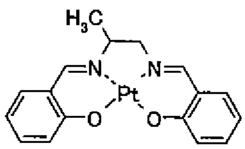

(1-3)

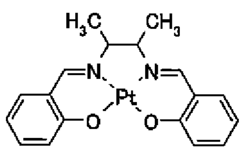

(1-4)

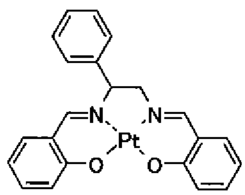

(1-5)

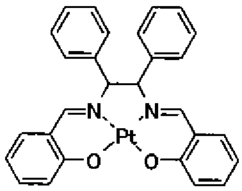

(1-6)

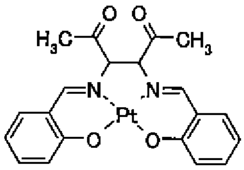

(1-7)

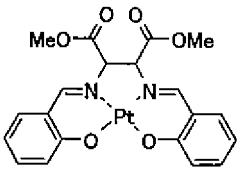

(1-8)

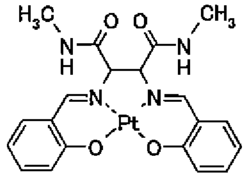

(1-9)

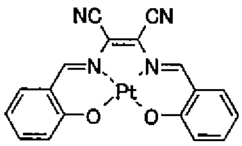

(1-10)

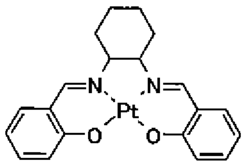

(1-11)

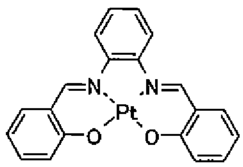

(1-12)

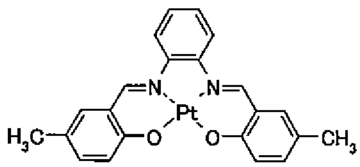

(1-13)

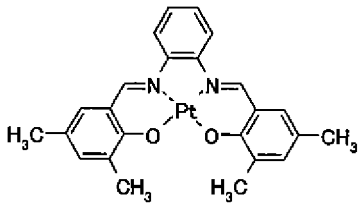

(1-14)

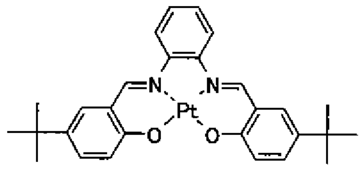

(1-15)

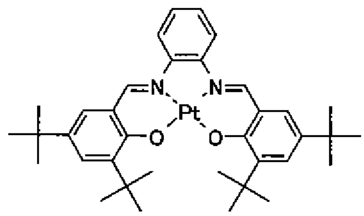

(1-16)

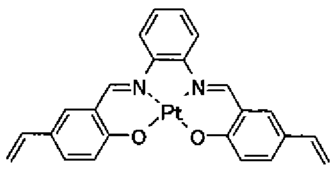

(1-17)

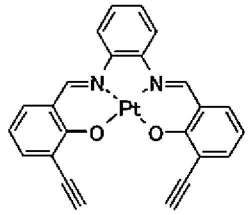

(1-18)

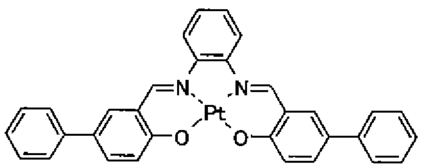

(1-19)

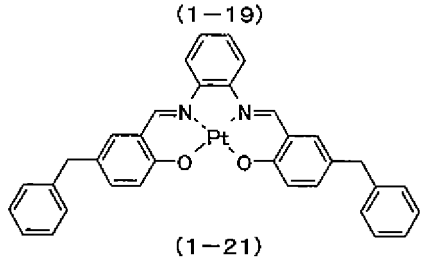

(1-20)

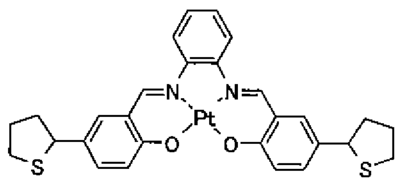

(1-21)

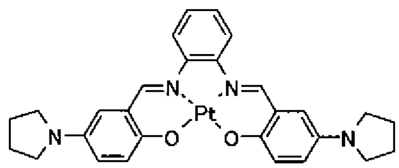

(1-22)

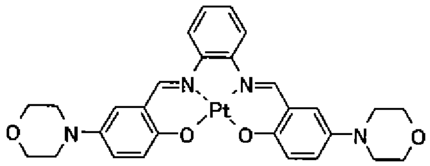

(1-23)

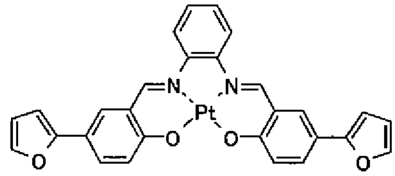

(1-24)

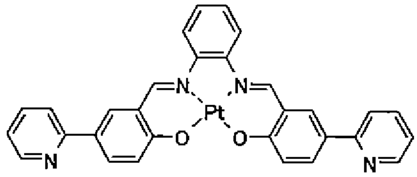

(1-25)

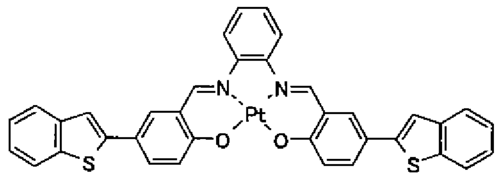

(1-26)

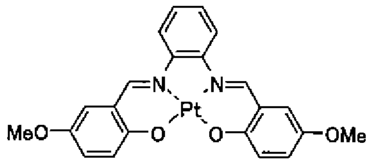

(1-27)

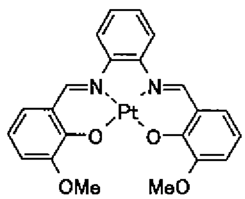

(1-28)

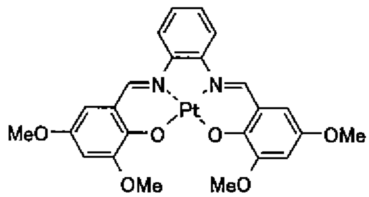

(1-29)

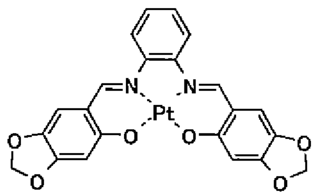

(1-30)

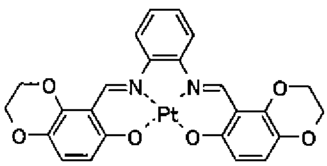

(1-31)

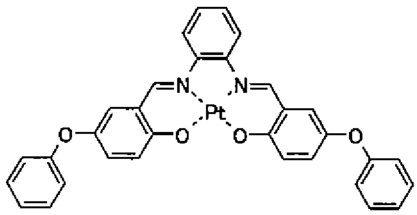

(1-32)

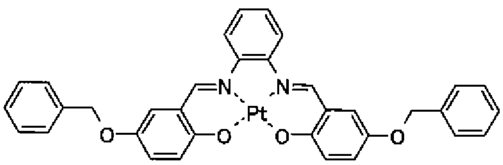

(1-33)

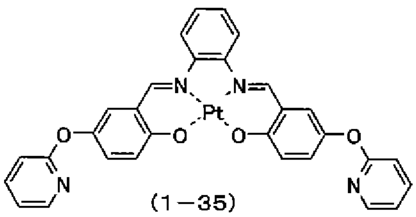

(1-34)

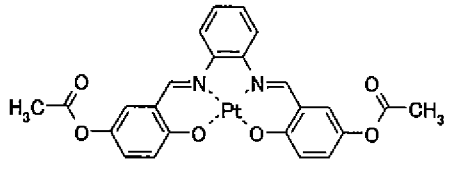

(1-35)

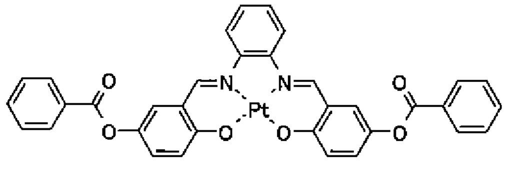

(1-36)

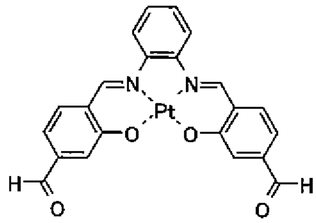

(1-37)

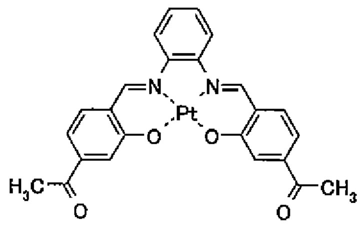

(1-38)

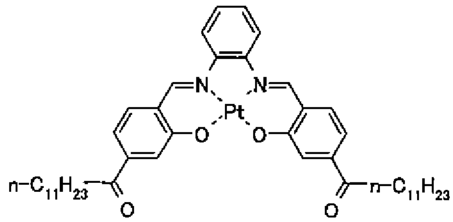

(1-39)

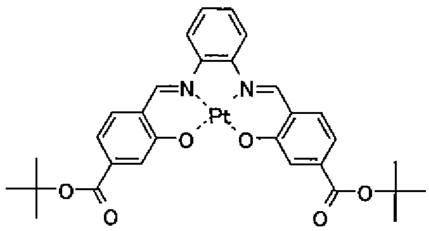

(1-40)

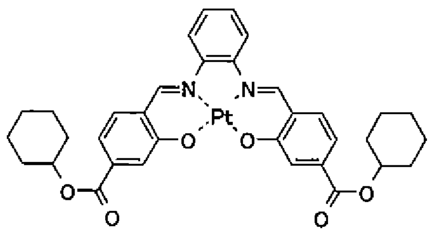

(1-41)

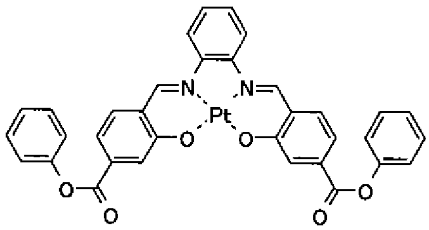

(1-42)

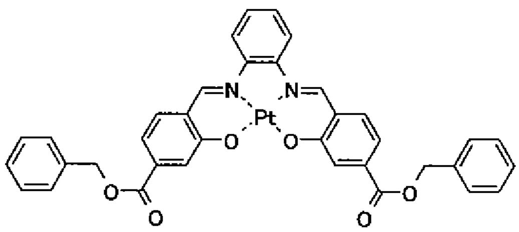

(1-43)

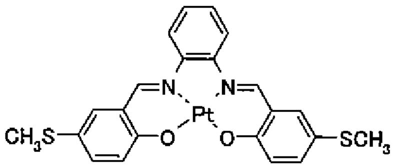

(1-44)

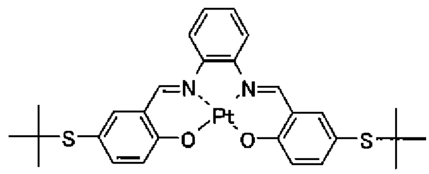

(1-45)

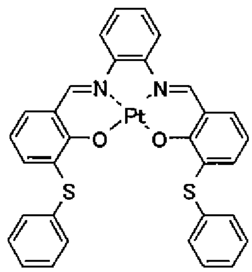

(1-46)

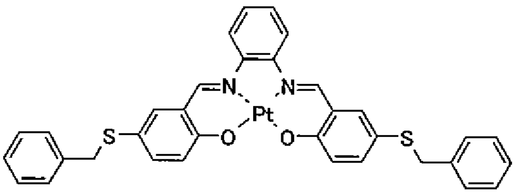

(1-47)

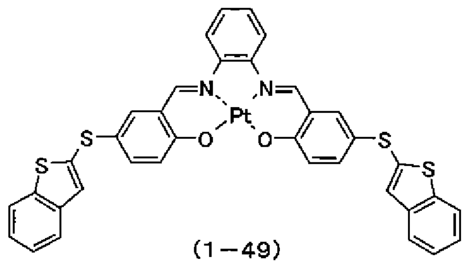

(1-48)

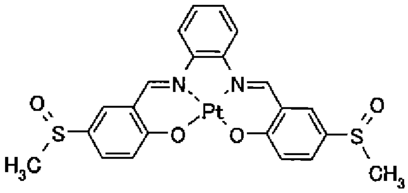

(1-49)

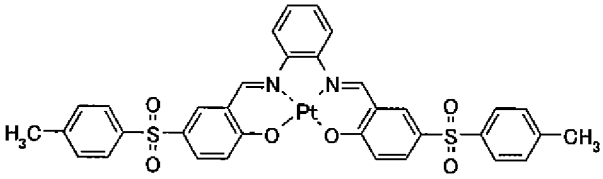

(1-50)

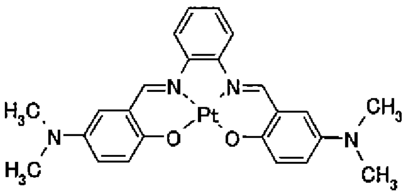

(1-51)

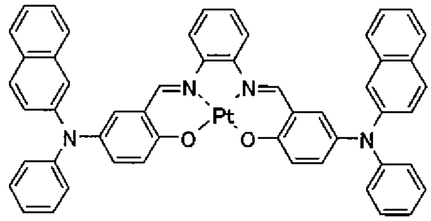

(1-52)

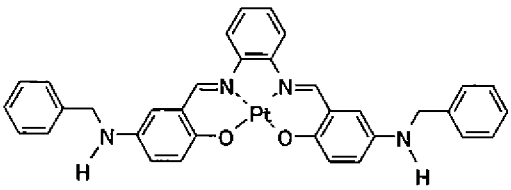

(1-53)

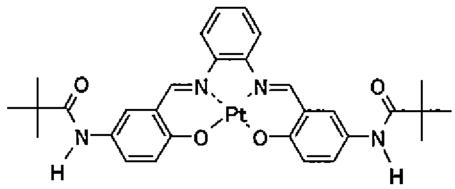

(1-54)

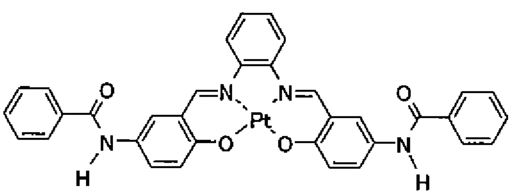

(1-55)

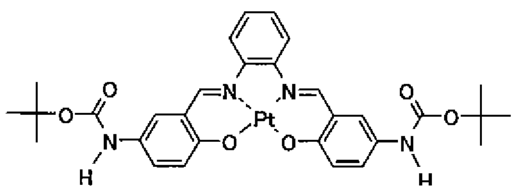

(1-56)

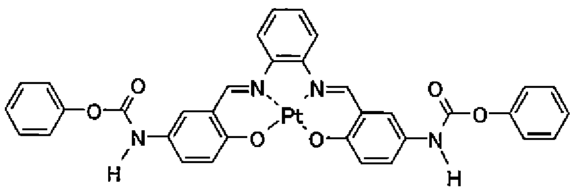

(1-57)

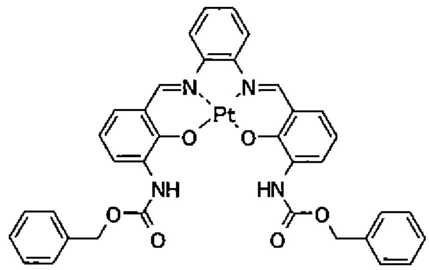

(1-58)

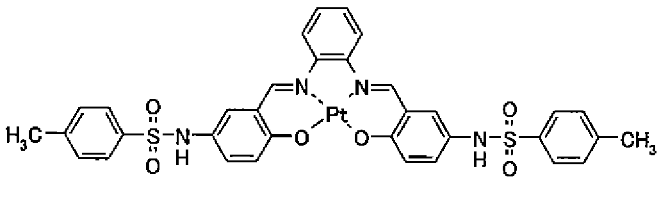

(1-59)

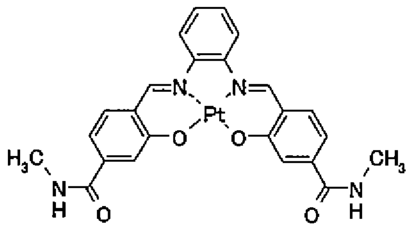

(1-60)

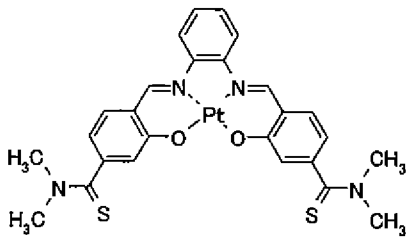

(1-61)

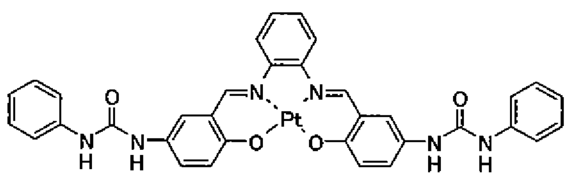

(1-62)

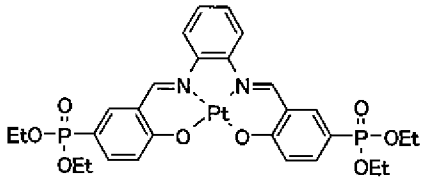

(1-63)

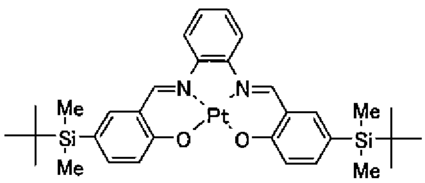

(1-64)

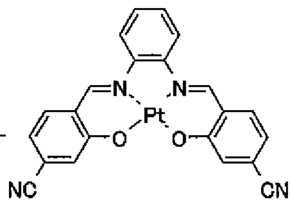

(1-65)

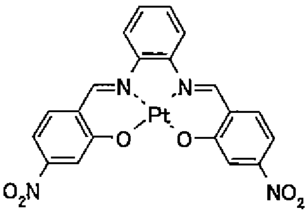

(1-66)

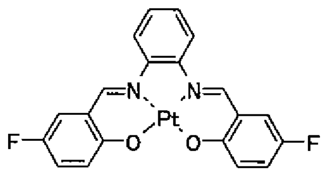

(1-67)

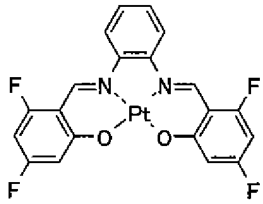

(1-68)

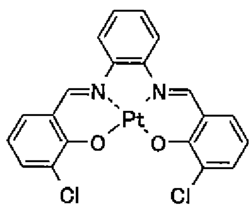

(1-69)

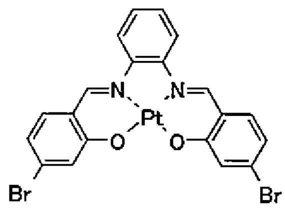

(1-70)

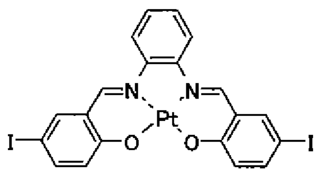

(1-71)

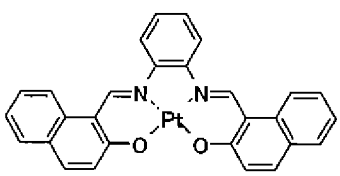

(1-72)

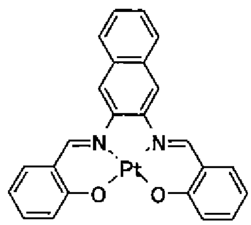

(1-73)

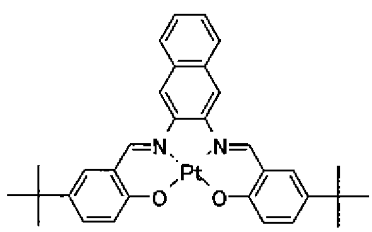

(1-74)

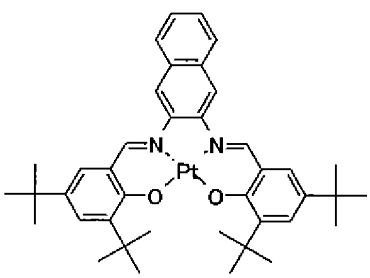

(1-75)

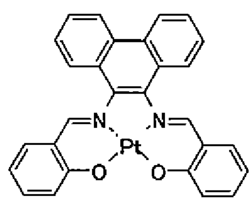

(1-76)

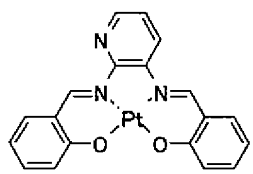

(1-77)

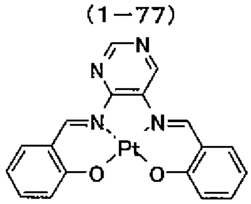

(1-78)

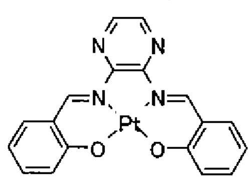

(1-79)

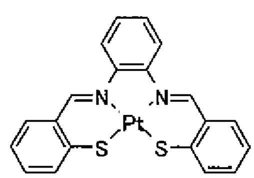

(1-80)

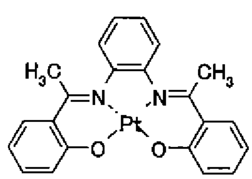

(1-81)

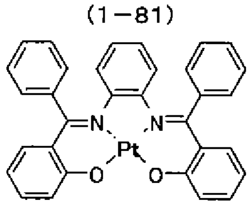

(1-82)

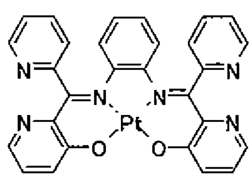

(1-83)

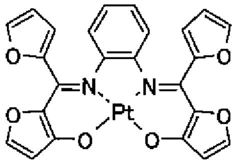

(1-84)

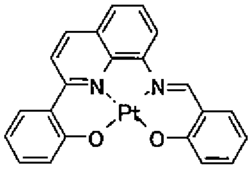

(1-85)

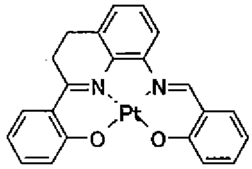

(1-86)

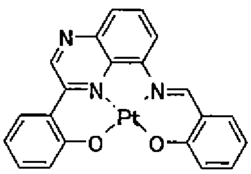

(1-87)

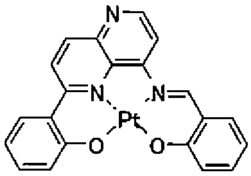

(1-88)

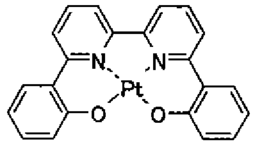

(1-89)

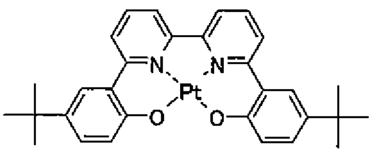

(1-90)

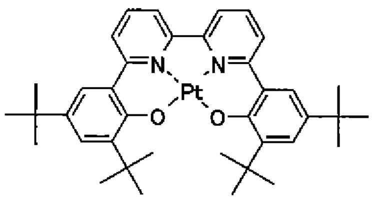

(1-91)

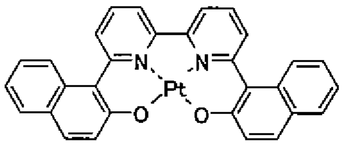

(1-92)

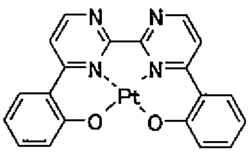

(1-93)

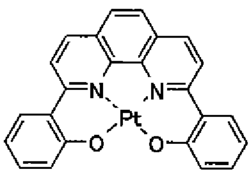

(1-94)

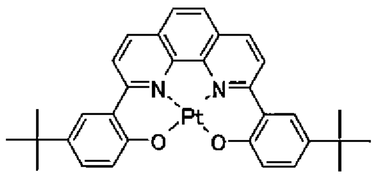

(1-95)

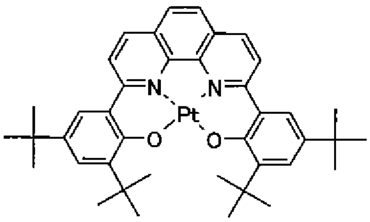

(1-96)

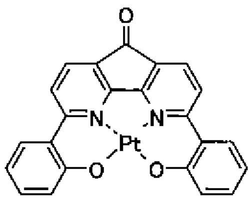

Hereinafter, methods of preparing the platinum complex represented by the general formula (1) (hereinafter, referred to as platinum complex (1)) used in the light-emitting device according to the present invention will be described with reference to the following reaction scheme.

<Scheme 1>

Complex Precusor +

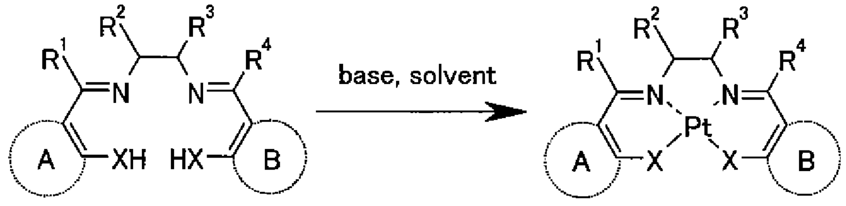


General Formula (2) General Formula (1)

The platinum complex (1) can be produced easily by reacting a complex precursor with a compound represented by the general formula (2) (hereinafter, referred to as compound (2)) in the presence of suitable bases and suitable solvents, under an inert gas atmosphere as needed.

Hereinafter, raw compounds for the platinum complex (1) of the present invention will be described.

In Scheme 1, the complex precursor may be an inorganic platinum compound or an organic platinum complex, and an organic platinum complex is more preferable. Favorable examples of the inorganic platinum compounds include compounds represented by $PtY_2$ (Y represents a halogen atom.) and $M_2PtY_4$ (Y represents a halogen atom, and M represents an alkali metal.). The halogen atom represented by Y includes a fluorine atom, a chlorine atom, a bromine atom, and an iodine atom. The alkali metal represented by M includes lithium, sodium, potassium, and the like. Typical examples of the inorganic platinum compound include platinum (II) chloride, platinum (II) bromide, platinum (II) iodide, sodium chloroplatinate (II), potassium chloroplatinate (II), potassium bromoplatinate (II), and the like. Preferable organic platinum complexes are the platinum diene complexes represented by general formula (3):

$$Pt(J)Y_2$$

wherein, J represents a non-conjugated diene compound, and Y represents a halogen atom.

In the general formula (3), the non-conj ugated diene compound represented by J may be a cyclic or non-cyclic compound, and if the non-conj ugated diene compound is a cyclic non-conj ugated diene compound, it may be either mono-cyclic, poly-cyclic, fused cyclic, or bicyclo compound. The non-conjugated diene compound may be substituted with substituent(s). The substituents thereof are not particularly limited as long as it does not affect the production method of the present invention, and the substituents are preferably similar to the substituents described in detail in the description for the platinum complexes. Preferable examples of non-conjugated diene compounds include 1,5-cyclooctadine, bicyclo [2,2,1]hepta-2,5-diene, 1,5-hexadiene, and the like. Particularly preferable non-conjugated diene compound is 1,5-hexadiene. Examples of the halogen atom represented by Y include a fluorine atom, a chlorine atom, a bromine atom, and an iodine atom, and in particular, chlorine and bromine atoms are preferable.

In Scheme 1, the compound (2) is a tetradentate ligand having two nitrogen atoms capable of coordinating to platinummetal center and two hydroxyl or mercapto groups capable of binding to the platinum. In the general formula (2), ring A, ring B, X, $R^1$, $R^2$, $R^3$and $R^4$ are the same as those described above. Typical examples of the compound (2) include compounds (2-1) to (2-96), which are compounds wherein in the compounds (1-1) to (1-96) represented as the typical examples of the platinum complexes of the invention, the platinum thereof were taken away and a hydrogen atom was bonded to each of atoms corresponding to the groups X in the general formula (1).

Next, the method for producing the platinum complex (1) will be described hereinafter. The amount of the compound (2) used is normally 0.5 to 20 equivalents, preferably 0.8 to 10 equivalents, and more preferably 1.0 to 2.0 equivalents, with respect to the amount of complex precursor.

In the scheme above, the production of the platinum complex (1) is preferably carried out in the presence of solvent(s). Preferable examples of the solvent include amides such as N,N-dimethylformamide, formamide, and N, N-dimethylacetamide; cyano-containing organic compounds such as acetonitrile; halogenated hydrocarbons such as dichloromethane, 1,2-dichloroethane, chloroform, carbon tetrachloride, and o-dichlorobenzene; aliphatic hydrocarbons such as pentane, hexane, heptane, octane, decane, and cyclohexane; aromatic hydrocarbons such as benzene, toluene, and xylene; ethers such as diethyl ether, diisopropyl ether, tert-butylmethyl ether, dimethoxy ethane, ethylene glycol

diethyl ether, tetrahydrofuran, 1,4-dioxane, and 1,3-dioxolane; ketones such as acetone, methylethylketone, methylisobutylketone, and cyclohexanone; alcohols such as methanol, ethanol, 2-propanol, n-butanol, and 2-ethoxyethanol; polyhydric alcohols such as ethylene glycol, propylene glycol, 1,2-propanediol, and glycerol; esters such as methyl acetate, ethyl acetate, n-butyl acetate, and methyl propionate; sulfoxides such as dimethylsulfoxide; water; and the like. These solvents may be used alone or in combination of two or more as needed. More preferable examples of the solvents include amides such as N,N-dimethylformamide and N,N-dimethylacetamide; cyano-containing organic compounds such as acetonitrile; ethers such as ethylene glycol diethyl ether, tetrahydrofuran, 1,4-dioxane, and 1,3-dioxolane; ketones such as acetone, methylethylketone, and methylisobutylketone; alcohols such as methanol, ethanol, 2-propanol, n-butanol, and 2-ethoxyethanol; polyhydric alcohols such as ethylene glycol, propylene glycol, 1,2-propanediol, and glycerol; esters suchasmethyl acetate, ethyl acetate, n-butyl acetate, and methyl propionate; water; and the like. These solvents may be also used alone or in combination with two or more as needed, and solvents mixed with water are particularly preferable. The amount of the solvent used is not particularly limited as long as the reaction proceeds smoothly, but the volume of the solvent is properly selected in the range normally by 1 to 200 parts, preferably by 1 to 50 parts, with respect to 1 part of complex precursor.

The reaction is favorably carried out in the presence of base(s). The base is, for example, an inorganic or organic base. Favorable examples of the inorganic base include alkali metal hydroxides such as lithium hydroxide, sodium hydroxide, and potassium hydroxide; alkali metal carbonates such as lithium carbonate, sodium carbonate, and potassium carbonate; alkalimetal bicarbonates such as sodiumbicarbonate and potassium bicarbonate; metal hydrides such as sodium hydride; and the like. Preferable examples of the organic bases include alkali metal alkoxides such as lithium methoxide, sodium methoxide, potassium methoxide, sodium ethoxide, potassium ethoxide, and potassium tert-butoxide; organic amines such as triethylamine, diisopropylethylamine, N,N-dimethylaniline, piperidine, pyridine, 4-dimethylaminopyridine, 1,5-diazabicyclo[4,3,0]non-5-ene, 1,8-diazabicyclo[5,4,0]undec-7-ene, tri-n-butylamine, and N-methylmorpholine; organic alkali metal compounds such as n-butyllithium and tert-butyllithium; Grignard reagents such as n-butylmagnesium chloride, phenylmagnesium bromide, and methylmagnesium iodide; and the like. The amount of the base used is properly selected normally in the range of 1 to 10 equivalents, preferably 1.5 to 5 equivalents, and more preferably 2 to 3 equivalents, with respect to that of the tetradentate ligand.

In the production method, three raw materials, the complex precursor, the compound (2) and the base(s), may be mixed simultaneously to initiate reaction, or the complex precursor may be added to a reaction mixture obtained by reaction of the compound (2) and the base (s) . Alternatively, the reaction mixture obtained by reaction of the compound (2) and the base(s) may be added to the complex precursor.

The production method described above is preferably carried out under an inert gas atmosphere. Examples of the inert gas include nitrogen gas, argon gas, and other gases. The production method may also be carried out in combination with an ultrasonic generator. The reaction temperature is selected properly, normally in the range of 25 to 300°C, preferably 60 to 200°C, and more preferably 80 to 150°C. The reaction time differs depending on the reaction conditions such as reaction temperature, a solvent used, and a base used. Generally the reaction time is selected properly in the range of normally 10 minutes to 72 hours, preferably 30 minutes to 48 hours, and more preferably 1 to 12 hours.

The platinum complex obtained may be additionally post-treated, isolated and purified, as needed. The post-treatment methods include, for example, extraction of reaction product, filtration of precipitate, crystallization by addition of solvent (s), distillation of solvent (s), and the like, and these post-treatments may be carried out alone or in combination. The methods for isolation or purification include, for example, column chromatography, recrystallization, sublimation, and the like, and these methods may be used alone or in combination.

The platinum complexes (1) obtained by the production method described above is useful as phosphorescent materials in light-emitting devices, in particular in organic EL devices.

The light-emitting device of the present invention will be described hereinafter. The light-emitting device of the present invention is not particularly limited in system, driving method, or application as long as it is a device utilizing the platinum complex (1) . A device utilizing light emission from the platinum complex or utilizing the platinum complex as a charge transporting material is preferable. A typical light-emitting device is an organic EL device.

The light-emitting device of the present invention will do as long as it contains at least one of the platinum complex (1). That is, the light-emitting device has a light-emitting layer or organic compound-containing multiple layers including a light-emitting layer between a pair of electrodes, wherein at least one of the platinum complex (1) is contained in at least one of the layers. The platinum complex (1) may be contained alone, or in suitable combination of two or more. For example when used as a material for doping the light-emitting layer of an organic EL device, the platinum complex (1) gives a device superior in color purity, and higher in external quantum efficiency and power efficiency than those of the conventional devices.

The method of forming the organic layer (organic compound layer) in the light-emitting device of the present invention is not particularly limited. Examples the method include aresistance-heating evaporative deposition method, an electron beam method, a sputtering method, a molecule accumulation method, a coating method, an inkjet method,

and the like, and the resistance-heating evaporative deposition method and the coating method are preferable from the points of properties and production efficiency of the organic compound layer.

The light-emitting device of the present invention is a device having a light-emitting layer or multiple-layered organic compound thin films including a light-emitting layer formed between a pair of electrodes, anode and cathode, andmaycontain, in addition to the light-emitting layer, a hole injecting layer, a hole transporting layer, an electron injecting layer, an electron transporting layer, a protecting layer, or the like; and each of these layers may have another function additionally. Any one of known materials may be used for formation of each of these layers. Hereinafter these layers will be described in more details.

The anode, which supplies holes to the hole injecting layer, the hole transporting layer, the light-emitting layer, and the like, and is made of a material such as metal, alloy, metal oxide, electrically conductive compound, or the mixture thereof, that has preferably a work function of 4eV or more. Typical examples thereof include conductive metal oxides such as tin oxide, zinc oxide, indium oxide, and indium tin oxide (hereinafter, referred to as "ITO"); metals such as gold, silver, chromium, and nickel; mixtures or deposits of the metal and the conductive metal oxide; inorganic conductive substances such as copper iodide and copper sulfide; organic conductive materials such as polyaniline, polythiophene, and polypyrrole; and deposits of the organic conductive material and ITO. Of these, conductive metal oxides are preferable, and particularly preferable is ITO from the points, for example, of productivity, conductivity, and transparency. The anode layer is selected properly depending on the material used, and the thickness is selected normally, preferably in the range of 10 nm to 5 $\mu$m, more preferably 50 nm to 1 $\mu$m, and still more preferably 100 to 500 nm.

The anode is normally formed as a layer on a substrate, for example, of soda lime glass, non-alkali glass, transparent resin, or the like. When glass is used as a substrate material, use of non-alkali glass is preferable from the viewpoint of reducing the amount of ions eluting from the glass. Alternatively, when soda lime glass is used as a substrate material, use of a glass barrier-coated, for example, with silica and the like is preferable. The thickness of the substrate is not particularly limited as long as the substrate has a sufficiently high mechanical strength, and if glass is used, the thickness of the glass substrate is normally 0.2 mm or more, preferably 0.7 mm or more. Various methods may be used for production of the anode depending on the material used, and, for example in production of an ITO anode, the ITO film is formed, for example, by an electron beammethod, a sputtering method, a resistance-heating evaporative deposition method, a chemical reaction method (e.g., sol-gel method), a coating method with an ITO dispersion, or the like. The drive voltage of the device can be reduced and the power efficiency of the device can be heightened, for example, by cleaning or other treatments of the anode. In the case of an ITO anode, for example, a UV Ozone or plasma treatment is effective as the treatments.

The cathode injects electrons to the electron injecting layer, the electron transporting layer, the light-emitting layer, and the like, and is selected, taking into consideration the adhesiveness of the negative electrode to the neighboring layer such as the electron injecting layer, the electron transporting layer, the light-emitting layer, or the like; and the ionization potential, stability, and others thereof. Examples of the cathode materials include metals, alloys, metal halides, metal oxides, electrically conductive compounds, and the mixtures thereof. Typical examples thereof include alkali metals such as lithium, sodium, and potassium and the fluorides thereof; alkali-earth metals such as magnesium and calcium and the fluorides thereof; gold, silver, lead, aluminum, sodium-potassium alloy, and the mixed metals thereof; magnesium-silver alloy or the mixed metals thereof; rare-earth metals such as indium and ytterbium; and the like. Favorable cathode materials have a work function of 4eV or less, and more preferable materials are aluminum, lithium-aluminum alloy or the mixed metals thereof, magnesium-silver alloy or the mixed metals thereof, and the like.

The cathode may have a deposited structure containing the compounds and mixtures described above. The thickness of the cathode layer can be selected properly depending on the material used, and is selected normally, preferably in the range of 10 nm to 5 $\mu$m, more preferably 50 nm to 1 $\mu$m, and still more preferably 100 nm to 1 $\mu$m. Methods such as an electronbeammethod, a sputtering method, a resistance-heating evaporative deposition method, a coating method, or the like are used for production of the cathode, and in deposition, a single metal may be deposited or two or more metals may be deposited simultaneously. Alternatively, the cathode may be formed by simultaneous deposition of multiple metals or by deposition of an alloy previously prepared. And it is preferable that the sheet resistance of the cathode or the anode is lower.

The material for the light-emitting layer is not particularly limited as long as it provides a light-emitting layer with functions allowing injection of electrons from the anode or the hole injecting or transporting layer, and allowing emission of light by providing the field for recombination of the electrons with holes when an electric field is applied. The light-emitting layer may be doped with a fluorescent or phosphorescent material higher in luminous efficiency. Examples thereof include benzoxazole derivatives, triphenylamine derivatives, benzimidazole derivatives, benzothiazole derivatives,styrylbenzene derivatives,polyphenyl derivatives, diphenylbutadiene derivatives, tetraphenylbutadiene derivatives, naphthalimide derivatives, coumarin derivatives, perylene derivatives, perynone derivatives, oxadiazole derivatives, aldazine derivatives, pyrralizine derivatives, cyclopentadiene derivatives, bisstyrylanthracene derivatives, quinacridone derivatives, pyrrolopyridine derivatives, thiadiazopyridine derivatives, styrylamine derivatives, aromatic dimethylidyne compounds, various metal complex represented by metal and rare-earth complexes of 8-quinolinol derivatives, polymer

compounds such as polythiophene, polyphenylene, polyphenylenevinylene, organic silane derivatives, the platinum complex (1) of the present invention, and the like. The light-emitting layer may have a single layer structure-consisting of one or more of the materials described above, or a multilayer structure having multiple layers of the same composition or different compositions. The thickness of the light-emitting layer is not particularly limited, and is selected normally, preferably in the range of 1 nm to 5 μm, more preferably 5 nm to 1 μm, and still more preferably 10 to 500 nm. The method of producing the light-emitting layer is not particularly limited, and examples thereof include methods such as an electron beam method, a sputtering method, a resistance-heating evaporative deposition method, a molecular accumulation method, coating methods (e.g., spin coating, casting, dip coating, etc.), an inkjet method, an LB (Langmuir-Brodget) method, and the like; and preferable are the resistance-heating evaporative deposition method and coating methods.

The material for the hole injecting layer or the hole transporting layer should have any one of functions of injecting holes from the anode, transporting the holes, and blocking electrons injected from the cathode. Typical examples of the material for the hole injecting layer or the hole transporting layer include carbazole derivatives, triazole derivatives, oxadiazole derivatives, oxazole derivatives, imidazole derivatives,polyarylalkane derivatives,pyrazolinederivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidyne compounds, porphyrin compounds, polysilane compounds, poly(N-vinylcarbazole) derivatives, aniline copolymers, thiophene oligomer, and oligomers of conductive polymers such as polythiophene, organic silane derivatives, the platinum complex (1) of the present invention, and the like. The thickness of the hole injecting layer or the hole transporting layer is not particularly limited, and is selected normally preferably in the range of 1 nm to 5 μm, more preferably 5 nm to 1 μm, and still more preferably 10 to 500 nm. The hole injecting layer or the hole transporting layer may have a single layer structure of one or more of the materials described above, or a multilayer structure consisting of multiple layers of the same composition or different compositions. For production of the hole injecting layer or the hole transporting layer, methods such as a vacuum deposition method, an LB method, a method of coating a solution or dispersion of the hole injecting or the hole transporting agent in solvent(s) (e.g., spin coating, casting, dip coating, etc.), an inkjet method, or the like is used. In the case of the coating method, the materials above can be dissolved together with resin component (s) in solvent (s). Examples of the resin component include polyvinyl chloride, polycarbonate, polystyrene, polymethyl methacrylate, polybutyl methacrylate, polyester, polysulfone, polyphenylene oxide, polybutadiene, poly(N-vinylcarbazole), hydrocarbon resins, ketone resins, phenoxy resins,polyamide,ethylcellulose,polyvinyl acetate,ABS resins, alkyd resins, epoxy resins, silicone resins, and the like.

Anymaterial may be used in the electron injecting or electron transporting layer, as long as it has a function of injecting electrons from the cathode, transporting the electrons, or blocking holes injected from the anode. The ionization potential of the hole blocking layer having a function of blocking holes injected from the anode is set to a value higher than that of the light-emitting layer.

Typical examples of the material for the electron injecting or electron transporting layer include triazole derivatives, oxazole derivatives, polycyclic compounds, hetero polycyclic compounds such as bathocuproin, oxadiazole derivatives, fluorenone derivatives, diphenylquinone derivatives, thiopyran dioxide derivatives, anthraquinonedimethane derivatives, anthrone derivatives, carbodiimide derivatives, fluorenylidenemethane derivatives, distyrylpyrazine derivatives, acid anhydrides for example of naphthalenetetracarboxylic acid and perylenetetracarboxylic acid, phthalocyanine derivatives, various metal complexes of the compounds represented by metal complexes of 8-quinolinol derivatives, metal phthalocyanines, and metal complexes having benzoxazole or benzothiazole as a ligand, organic silane derivatives, the platinum complex (1) of the present invention, and the like. The thickness of the electron injecting or electron transporting layer is not particularly limited, and is selected normally, preferably in the range of 1 nm to 5 μm, more preferably 5 nm to 1 μm, and still more preferably 10 to 500 nm. The electron injecting or electron transporting layer may have a single layer structure consisting of one or more of the materials described above or a multilayer structure having multiple layers consisting of the same composition or different compositions. For production of the electron injecting or electron transporting layer, methods such as a vacuum deposition method, an LB method, a method of coating a solution or dispersion of the electron injecting or electron transporting agent in solvent (s) (e.g., spin coating, casting, dip coating, etc.), an inkjet method, or the like may be used. In the case of the coating method, the material can be dissolved or dispersed together with resin component in solvent(s), and the resins exemplified for the hole injecting or hole transporting layer may be used as the resin components.

Any material may be used as the material for protecting layer as long as it has a function of preventing intrusion of the compounds that accelerate degradation of the device such as water and oxygen into the device. Typical examples of the material for protecting layer includemetals such as indium, tin, lead, gold, silver, copper, aluminum, titanium, and nickel; metal oxides such as magnesium oxide, silicon dioxide, dialuminum trioxide, germanium oxide, nickel oxide, calcium oxide, barium oxide, diiron trioxide, diytterbium trioxide, and titanium oxide; metal fluorides such as magnesium fluoride, lithium fluoride, aluminum fluoride, and calcium fluoride; polyethylene, polypropylene, polymethyl methacrylate,

polyimide, polyurea, polytetrafluoroethylene, polychlorotrifluoroethylene, polydichlorodifluoroethylene, copolymers of chlorotrifluoroethylene and dichlorodifluoroethylene, copolymers obtained by copolymerizing a monomer mixture containing tetrafluoroethylene and at least one comonomer, fluorine-containing copolymers having a cyclic structure in the capolymer main chain, water-absorbing substances having a water absorption of 1% or more, moisture-proof substances having a water absorption of 0.1% or less, and the like. The method of producing the protecting layer is also not particularly limited, and the protecting layer can be prepared, for example, by a vacuum deposition method, a sputtering method, a reactive sputtering method, an MBE (molecular beam epitaxy) method, a cluster ion beam method, an ion plating method, a plasma polymerization (high-frequency wave excitation ion plating) method, a plasma CVD method, a laser CVD method, a thermal CVD method, a gas source CVD method, or a coating method.

## BEST MODE FOR CARRYING OUT THE INVENTION

Hereinafter, the present invention will be described more specifically with reference to Examples, Reference Examples, and Comparative Examples, but it should be understood that the present invention is not limited by these examples at all.

The apparatuses used for measurement in Reference Examples below are as follows:

(1) 200 MHz $^1$H-NMR spectrum analysis: GEMINI 2000 (manufactured by Varian)
(2) 500 MHz $^1$H-NMR spectrum analysis: DRX-500 (manufactured by Bruker)
(3) UV-Visible Spectrometer: V-550 (manufactured by JASCO)
(4) Fluorescence Spectrophotometer: F-4500 (manufactured by Hitachi)

### Reference Example 1

Preparation of exemplary compound (2-11): 2,2'-[1,2-phenylene-bis(nitrilomethylidyne)]bisphenol

Into an ethanol (50 mL) solution of 1,2-phenylenediamine (2.5 g, 23.12 mmol, 1.0 equivalent), salicylaldehyde (5.4 mL, 50.86 mmol, 2.2 equivalents) was added dropwise, and the mixture was stirred under reflux for 3 hours. Crystals in the orange-colored suspension obtained were filtered, washed with ethanol and hexane, and dried by heating under reduced pressure, to give 7.0 g of the exemplary compound (2-11) in a form of orange-colored powder. Yield: 95.7%.
$^1$H NMR (200 MHz, $CDCl_3$): 6.92 (dt, J=0.6, 7.2Hz, 2H), 7.04 (d, J=6.4Hz, 2H), 7.18-7.46 (m, 8H), 8.64 (s, 2H), and 13.04 (s, 2H).

### Reference Example 2

Preparation of exemplary compound (2-14): 2,2'-[1,2-phenylene-bis(nitrilomethylidyne)]bis(4-tert-butylphenol)

To an ethanol (5 mL) solution of 1,2-phenylenediamine (276 mg, 2.55 mmol, 1.0 equivalent), an ethanol (5 mL) solution of 5-tert-butylsalicylaldehyde (1.00 g, 5.61 mmol, 2.2 equivalents) was added dropwise, and the mixture was stirred under reflux for 8 hours. Crystals were filtered from the orange-colored suspension obtained, washed with ethanol and hexane, and dried by heating under reduced pressure, to give 670 mg of the exemplary compound (2-14) in a form of orange-colored powder. Yield: 61.3%. $^1$H NMR (200 MHz, $CDCl_3$): 1.32 (s, 18H), 6.99 (d, J=8.6Hz, 2H), 7.15-7.48 (m, 8H), 8.64 (s, 2H), and 12.84 (s, 2H).

### Reference Example 3

Preparation of exemplary compound (2-15): 2,2'-[1,2-phenylene-bis(nitrilomethylidyne)]bis(4,6-di-tert-butylphenol)

To a mixture of 1,2-phenylenediamine (1.47 g, 13.58 mmol, 1.0 equivalent) and 3,5-di-tert-butylsalicylaldehyde (7.00 g, 29.87 mmol, 2.2 equivalents), ethanol (100 mL) was added, and the mixture was stirred under reflux for 40 hours. Crystals were filtered from the yellow orange-colored suspension obtained and dried by heating under reduced pressure, to give 5.90 g of the exemplary compound (2-15) in a formof yellow powder. The filtrate was concentrated to 20 mL and then stirred additionallyunder reflux for 48 hours to obtain yellow orange-colored suspension. Crystals were filtered from the yellow orange-colored suspension obtained and dried by heating under reduced pressure, to give still more 1.20 g of the exemplary compound (2-15) in a form of yellow powder. Total yield: 96.6%.
$^1$H NMR (500 MHz, $CD_2Cl_2$): 1.32 (s, 18H), 1.42 (s, 18H), 7.26 (d, J=2.4Hz, 2H), 7.27-7.37 (m, 4H), 7.45 (d, J=2.4Hz, 2H), 8.69 (s, 2H), and 13.59 (s, 2H).

Reference Example 4

Preparation of exemplary compound (2-26): 2,2'-[1,2-phenylene-bis(nitrilomethylidyne)]bis(4-methoxy-phenol)

To an ethanol (20 mL) solution of 1,2-phenylenediamine (787 mg, 7.28 mmol, 1.0 equivalent), added dropwise was 5-methoxysalicylaldehyde (2.0 mL, 16.02 mmol, 2.2 equivalents), and the mixture was stirred at room temperature for 8 hours. Crystals were filtered from the orange-colored suspension obtained and dried by heating under reduced pressure, to give 3.4 g of the exemplary compound (2-26) in a form of red orange-colored powder. Yield: 96.5%.
$^1$H NMR (200 MHz, $CDCl_3$): 3.80 (s, 6H), 6.89 (t, J=1.8Hz, 2H), 6.99 (d, J=1.8Hz, 4H), 7.20-7.40 (m, 6H), 8.60 (s, 2H), and 12.58 (s, 2H).

Reference Example 5

Preparation of exemplary compound (2-27) : 2,2'-[1,2-phenylene-bis(nitrilomethylidyne)]bis(6-methoxyphenol)

To a mixture of 1,2-phenylenediamine (1.0 g, 9.25 mmol, 1.0 equivalent) and o-vanillin (3.1 g, 20.35 mmol, 2.2 equivalents), added was ethanol (100 mL), and the mixture was stirred at room temperature for 8 hours. Crystals are filtered from the orange-colored suspension obtained and dried by heating under reduced pressure, to give 3.2 g of the exemplary compound (2-27) in a form of red orange-colored powder. Yield: 91.9%.
$^1$H NMR (200 MHz, $CDCl_3$): 3.90 (s, 6H), 6.86 (dd, J=7.6, 8.2Hz, 2H), 6.99 (t, J=7.4Hz, 2H), 7.00 (t, J=7.4Hz, 2H), 7.15-7.40 (m, 4H), 8.63 (s, 2H), and 13.17 (s, 2H).

Reference Example 6

Preparation of exemplary compound (2-72): 2,2'-[2,3-naphthalendiyl-bis(nitrilomethylidyne)]bisphenol

To an ethanol (150 mL) solution of 2,3-diaminonaphthalene (1.0 g, 6.32 mmol, 1.0 equivalent), added dropwise was salicylaldehyde (1.5 mL, 13.90 mmol, 2.2 equivalents), and the mixture was stirred under reflux for 8 hours. Crystals were filtered from the orange-colored suspension obtained and dried by heating under reduced pressure, to give 1.9 g of the exemplary compound (2-72) in a form of orange-colored powder. Yield: 81.3%. $^1$H NMR (200 MHz, $CDCl_3$): 6.95 (dt, J=1.0, 7.2Hz, 2H), 7.07 (d, J=8.0Hz, 2H), 7.34-7.55 (m, 6H), 7.60 (s, 2H), 7.81-7.95 (m, 2H), 8.75 (s, 2H), and 13.02 (s, 2H).

Reference Example 7

Preparation of exemplary compound (2-73): 2,2'-[2,3-naphthalendiyl-bis(nitrilomethylidyne)]bis(4-tertbutylphenol)

To an ethanol (100 mL) solution of 2,3-diaminonaphthalene (807 mg, 5.10 mmol, 1.0 equivalent), added dropwise was 5-tert-butylsalicylaldehyde (2.0 g, 11.22 mmol, 2.2 equivalents), and the mixture was stirred under reflux for 15 hours. Crystals were filtered from the orange-colored suspension obtained and dried by heating under reduced pressure, to give 1.44 g of the exemplary compound (2-73) in a form of orange-colored powder. Yield: 59.0%. $^1$H NMR (200 MHz, $CDCl_3$): 1.33 (s, 18H), 7.01 (dd, J=1.0, 8.2Hz, 2H), 7.41 (s, 2H), 7.45-7.55 (m, 4H), 7.59 (s, 2H), 7.80-7.92 (m, 2H), 8.75 (s, 2H), and 12.81 (s, 2H).

Reference Examples 8-1 to 8-3

Preparation of exemplary compound (2-88): 2,2'-(2,2'-bipyridine)-6,6'-diyl-bisphenol

Reference Example 8-1

Preparation of 6-(2-methoxyphenyl)-2,2'-bipyridine

A reaction flask equipped with a reflux condenser and a dropping funnel was dried by heating under reduced pressure, and the internal gas was substituted with nitrogen. Then, diethyl ether (20 mL) and lithium metal cubes (702 mg, 101.18 mmol, 2.1 equivalents with respect to 2-bromoanisole) were placed in a reactor, and a diethyl ether (20 mL) solution of 2-bromoanisole (6.0 mL, 48.18 mmol, 1.5 equivalents) was added dropwise over a period of 1 hour at a dropping velocity adjusted to make the content reflux gently. After dropwise addition, the mixture was heated under reflux additionally for 1 hour, to give a diethyl ether solution of 2-methoxyphenyllithium.

2,2'-bipyridine (5.0 g, 32.01 mmol, 1.0 equivalent) was placed in a reactor, and the internal gas was substituted with nitrogen. Then, after addition of diethyl ether (100 mL), the mixture was cooled to 5°C in an ice bath. The diethyl ether solution of 2-methoxyphenyllithium prepared above was added dropwise to the mixture over a period of 1 hour, and the mixture was stirred at room temperature additionally for 12 hours. The black purple reaction solution obtained was poured into a saturated aqueous ammonium chloride solution slowly, and after separation of the organic layer, the aqueous layer was extracted with methylene chloride. The organic layers were combined and concentrated under reduced pressure; the residue obtained was dissolved in acetone (50 mL) ; and an acetone (200 mL) solution of potassium permanganate (2.0 g, 12.66 mmol, 0.4 equivalents) was added dropwise thereto. Celite was added to the brown suspension obtained after dropwise addition; the mixture was suction-filtered; and the filtrate was concentrated, roughly purified by silica gel column chromatography (eluent: dichloromethane/ethyl acetate: 15/1), to give 3.9 g of an intermediate 6-(2-methoxyphenyl)-2,2'-bipyridine in a form of red viscous oil. Yield: 46.4%. The intermediate was used in the next reaction without further purification.
$^1$H NMR (200 MHz, $CDCl_3$): 3.88 (s, 3H), 7.03 (d, J=8.2Hz, 1H), 7.13 (dt, J=1.0, 7.4Hz, 1H), 7.29 (ddd, J=1.2, 4.8, 7.6Hz, 1H), 7.40 (ddd, J=1.0, 1.8, 7.4Hz, 1H), 7.74-7.84 (m, 2H), 7.92 (dd, J=1.2, 7.8Hz, 1H), 8.01 (dd, J=1.8, 7.8Hz, 1H), 8.34 (dd, J=1.2, 7.6Hz, 1H), 8.57 (dt, J=8.0, 1.0Hz, 1H), and 8. 68 (ddd, J=1.0, 1.8, 4.8Hz, 1H).

Reference Example 8-2

Preparation of 6,5'-di(2-methoxyphenyl)-2,2'-bipyridine

A diethyl ether solution of 2-methoxyphenyllithium was prepared in a similar manner to above from lithium metal cubes (325 mg, 46.85 mmol, 2.1 equivalents with respect to 2-bromoanisole), 2-bromoanisole (2.8 mL, 22.31 mmol, 1.5 equivalents) and diethyl ether (20 mL).

A diethyl ether (80 mL) solution of 6-(2-methoxyphenyl)-2,2'-bipyridine prepared in Reference Example 8-1 (3.9 g, 14.87 mmol, 1.0 equivalent) wasplacedinanitrogen-substitutedreaction flask and cooled to 5°C in an ice bath. To the solution, the diethyl ether solution of 2-methoxyphenyllithium prepared above was added over a period of 1 hour, and after dropwise addition, the mixture was stirred at room temperature additionally for 12 hours. The black purple reaction solution obtained was added to a saturated aqueous ammonium chloride solution slowly, and after separation of the organic layer, the aqueous layer was extracted with methylene chloride. The organic layers were combined and concentrated under reduced pressure; the residue obtained was dissolved in acetone (50 mL) ; and an acetone (100 mL) solution of potassium permanganate (1.0 g, 6.33 mmol, 0.4 equivalents) was added dropwise thereto. Celite was added to the suspension obtained after dropwise addition; the mixture was suction-filtered; and the filtrate was concentrated, then purified by silica gel column chromatography (eluent:dichloromethane),and recrystallized from hexane, to give 2.5 g of an intermediate, 6,6'-di(2-methoxyphenyl)-2,2'-bipyridine, in a form of cream-colored powder. Yield: 45.6%.
$^1$H NMR (200 MHz, $CDCl_3$): 3.90 (s, 6H), 7.04 (d, J=8. 4Hz, 2H), 7.14 (dt, J=1.0, 7.6Hz, 2H), 7.40 (ddd, J=1.0, 1.8, 7.4Hz, 2H), 7.82 (t, J=7.4Hz, 2H), 7.92 (dd, J=1.4, 8.0Hz, 2H), 8.04 (dd, J=1.8Hz, 7.6Hz, 2H), and 8.50 (dd, J=1.4, 7.4Hz, 2H).

Reference Example 8-3

Preparation of exemplary compound (2-88): 2,2'-(2,2'-bipyridine)-6,6'-diylbisphenol)

Pyridine (10.5mL, 130.20 mmol, 20.0 equivalents) was placed in a reaction flask, and concentrated hydrochloric acid (15.6 mL, 130.20 mmol, 20.0 equivalents) was added dropwise thereto. The solution obtained was heated until the internal temperature reaches 200°C, with removal of water. The content was cooled to 140°C; 6,5'-di(2-methoxyphenyl)-2,2'-bipyridine prepared in Reference Example 8-2 (2.4 g, 6.51 mmol, 1. 0 equivalent) was added thereto; and the mixture was stirred at 200°C for 3 hours. Yellow solid obtained by cooling the content was added into a suspension of dichloromethane and water, and 100 mL of an aqueous 1N sodium hydroxide solution was added dropwise thereto until the pH of the aqueous layer became 7.0. After separation of the organic layer, the aqueous layer was extracted with dichloromethane three times, and the organic layers were combined and concentrated under reduced pressure. The residue obtained was purified by silica gel column chromatography (eluent: dichloromethane) and recrystallized from hexane/dichloromethane, to give 2.0 g of the exemplary compound (2-88) in a form of cream-colored powder. Yield: 90.3%.
$^1$H NMR (500 MHz, $CD_2Cl_2$): 6.97 (ddd, J=1.2, 7.1, 8.0Hz, 2H), 7.03 (dd, J=1.2, 8.3Hz, 2H), 7.35 (ddd, J=1.6, 7.1, 8.3Hz, 2H), 7.91 (dd, J=1.6, 8.0Hz, 2H), 8.05 (dd, J=1.7, 7.9Hz, 2H), 8.08 (dd, J=7.4, 7.9Hz, 2H), 8.11 (dd, J=1.7, 7.4Hz, 2H), and 14.10 (s, 2H).

Reference Example 9

Preparation of exemplary compound (1-11): [[2,2'-[1,2-phenylene-bis(nitrilomethylidyne)]bis[phenolate]]-N,N',O,O']platinum (II)

Potassium chloroplatinate (II) (500 mg, 1.20 mmol, 1.0 equivalent), the exemplary compound (2-11) prepared in Reference Example 1 (418 mg, 1.32 mmol, 1.1 equivalents) and potassium hydroxide (168 mg, 3.00 mmol, 2.5 equivalents) were placed in a Schlenk flask and the internal gas was substituted with nitrogen. Then, acetone (10 mL) and water (10 mL) were added thereto in that order, and the mixture was stirred under reflux for 1 hour. After recovery of acetone from the suspension obtained, the crude crystals precipitated were filtered and washed with a saturated aqueous sodium bicarbonate solution. The crude crystals were purified by silica gel column chromatography (eluent: dichloromethane/ethyl acetate: 20/1), to give 399 mg of the exemplary compound (1-11) in a cotton-like state red substance. Yield: 65.3%. For use in production of an organic EL device, the compound is further purified by sublimation ($1.6x10^{-5}$ Torr, 300°C) in a sublimation yield of 83.8%, to give the exemplary compound (1-11) in a form of red powder.
$^1$H NMR (500 MHz, $CD_2Cl_2$) : 6.76 (ddd, J=1.1, 6.7, 7.9Hz, 2H), 7.23 (dt, 8.7,0.5Hz, 2H), 7.37 (dt, J=9.6, 3.3Hz, 2H), 7.55-7.64 (m, 4H), 7.99 (dt, J=9.6, 3.3Hz, 2H), 8.87 (s, 2H).
Emission wavelength ($CH_2Cl_2$): 612.0 nm (Excitation wavelength: 555.0 nm)

Reference Example 10

Preparation of exemplary compound (1-14): [[2,2'-[1,2-phenylene-bis(nitrilomethylidyne)]bis[4-tert-butylphenolate]]-N, N',O,O']platinum (II)

Potassium chloroplatinate (II) (500 mg, 1.20 mmol, 1.0 equivalent), the exemplary compound (2-14) prepared in Reference Example 2 (570 mg, 1.32 mmol, 1.1 equivalents) and potassium hydroxide (168 mg, 3.00 mmol, 2.5 equivalents) were placed in a Schlenk flask and the internal gas was substituted with nitrogen. Then, acetone (10 mL) and water (10 mL) were added thereto in that order, and the mixture was stirred under reflux for 1 hour. After recovery of acetone from the suspension obtained, the crude crystals precipitated were filtered and washed with a saturated aqueous sodium bicarbonate solution. The crude crystals were purified by silica gel column chromatography (eluent: dichloromethane/ethyl acetate: 20/1), to give 321 mg of the exemplary compound (1-14) in a form of purple powder. Yield: 43.0%. For use in production of an organic EL device, the compound is further purified by sublimation ($1.3x10^{-5}$ Torr, 330°C) in a sublimation yield of 81.4%, to give the exemplary compound (1-14) in a form of red powder.
$^1$H NMR (500 MHz, $CD_2Cl_2$): 1.35 (s, 18H), 7.18 (d, J=9.1Hz, 2H), 7. 33 (dt, J=9. 6, 3. 3Hz, 2H), 7.50 (d, J=2.6Hz, 2H), 7.66 (dd, J=2. 6, 9.1Hz, 2H), 7.98 (dt, J=9.6, 3.3Hz, 2H), and 8.87 (s, 2H).

Reference Example 11

Preparation of exemplary compound (1-15): [[2,2'-[1,2-phenylene-bis(nitrilomethylidyne)]bis[4,6-di-tert-butylphenolate]] -N,N',O,O']platinum (II)

[(1,2,5,6-$\eta^4$)-1,5-hexadienyl]platinum(II) dichloride (300 mg, 0.862 mmol, 1.0 equivalent), the exemplary compound(2-15) prepared in Reference Example 3 (513 mg, 0.948 mmol, 1.1 equivalents) and potassium hydroxide (121 mg, 2.155 mmol, 2.5 equivalents) were placed in a Schlenk flask, and the internal gas was substituted with nitrogen. Then, 2-ethoxyethanol (30 mL) was added thereto, and the mixture was stirred under reflux for 1 hour. The residue obtained after evaporation of the solvent from the reaction solution was purified by silica gel column chromatography (eluent: hexane/toluene: 1/1) and recrystallization (solvent: methanol), to give 432 mg of the exemplary compound (1-15) in a form of red powder. Yield: 68.3%. For use in production of an organic EL device, the compound is further purified by sublimation ($8.0 \times 10^{-6}$ Torr, 300°C) in a sublimation yield of 82.1%, to give the exemplary compound (1-15) in a form of red powder.
$^1$H NMR (500 MHz, $CD_2Cl_2$) : 1.36 (s, 18H), 1.56 (s, 18H), 7.30-7.34 (m, 2H), 7.38 (d, J=2.6Hz, 2H), 7.68 (d, J=2.6Hz, 2H), 7.98-8.03 (m, 2H), and 8.91 (s, 2H).
Fluorescence emission wavelength: 639.6 nm (excitation wavelength: 575.0 nm)

Reference Example 12

Preparation of exemplary compound (1-26): [[2,2'-[1,2-phenylene-bis(nitrilomethylidyne)]bis[4-methoxyphenolate]]-N, N',O,O']platinum (II)

Potassium chloroplatinate (II) (500 mg, 1.20 mmol, 1.0 equivalent), the exemplary compound (2-26) prepared in Reference Example 4 (499 mg, 1.32 mmol, 1.1 equivalents) and potassium hydroxide (168 mg, 3.00 mmol, 2.5 equivalents) were placed in a Schlenk flask, and the internal gas was substituted with nitrogen. Then, acetone (10 mL) and water (10 mL) were added thereto in that order, and the mixture was stirred under reflux for 1 hour. After recovery of acetone from the suspension obtained, the crude crystals precipitated were filtered and washed with a saturated aqueous sodium bicarbonate solution. The crude crystals were purified by silica gel column chromatography (eluent: dichloromethane/methanol: 20/1), to give 367 mg of the exemplary compound (1-26) in a form of black brown powder. Yield: 53.7%. $^1$H NMR (500 MHz, $CD_2Cl_2$) : 3.82 (s, 6H), 6.98 (d, J=3.2Hz, 2H), 7.19 (d, J=9.4Hz, 2H), 7.28 (dd, J=3.2, 9.4Hz, 2H), 7.36 (dt, J=9.6, 3.3Hz, 2H), 8.00 (dt, J=9.7, 3.3Hz, 2H), and 8.86 (s, 2H).

Reference Example 13

Preparation of exemplary compound (1-72): [[2,2'-[2,3-naphthalendiyl-bis(nitrilomethylidyne)]bis[phenolate]]-N,N',O,O'] platinum (II)

Potassium chloroplatinate (II) (500 mg, 120 mmol, 1.0 equivalent), the exemplary compound (2-72) prepared in Reference Example 6 (487 mg, 1.32 mmol, 1.1 equivalents) and potassium hydroxide (168 mg, 3.00 mmol, 2.5 equivalents) were placed in a Schlenk flask and the internal gas was substituted with nitrogen. Then, acetone (10 mL) and water (10 mL) were added thereto in that order, and the mixture was stirred under reflux for 1 hour. After recovery of acetone from the suspension obtained, the crude crystals precipitated were filtered and washed with a saturated aqueous sodium bicarbonate solution. The crude crystal was purified by silica gel column chromatography (eluent: dichloromethane/ethyl acetate: 10/1 and then dichloromethane/methanol =20/1), to give 377 mg of the exemplary compound (1-72) in a form of dark purple powder. Yield: 56.2%. For use in production of an organic EL device, the compound is further purified by sublimation ($8.0 \times 10^{-6}$ torr, 340°C) in a sublimation yield of 80.0%, to give the exemplary compound (1-72) in a form of dark purple powder.
$^1$H NMR (500 MHz, $CD_2Cl_2$): 6.81 (ddd, J=1.1, 6.7, 7.9Hz, 2H), 7.25 (d, J=8.6Hz, 2H), 7.56-7.64 (m, 4H), 7.69 (dd, J=1.8, 8.1Hz, 2H), 7.96-8.04 (m, 2H), 8.42 (s, 2H), and 9.13 (s, 2H).

Reference Example 14

Preparation of exemplary compound (1-73): [[2,2'-[2,3-naphthalendiyl-bis(nitrilomethylidyne)]bis[4-tert-butylphanolate]] -N,N',O,O']platinum (II)

Potassium chloroplatinate (II) (500 mg, 1.20 mmol, 1.0 equivalent), the exemplary compound (2-73) prepared in Reference Example 7 (636 mg, 1.32 mmol, 1.1 equivalents) and potassium hydroxide (168 mg, 3.00 mmol, 2.5 equivalents) were placed in a Schlenk flask and the internal gas was substituted with nitrogen. Then, acetone (10 mL) and water (10 mL) were added thereto in that order, and the mixture was stirred under reflux for 1 hour. After recovery of acetone from the suspension obtained, the crude crystals precipitated were filtered and washed with a saturated aqueous sodium bicarbonate solution. The crude crystals were purified by silica gel column chromatography (eluent: dichloromethane/ethyl acetate =50/1), to give 333 mg of an exemplary compound (1-73) in a cotton-like state red substance. Yield: 41.3%. For use in production of an organic EL device, the compound is further purified by sublimation ($4.0 \times 10^{-6}$ torr, 330°C) in a sublimation yield of 87.2%, to give the exemplary compound (1-73) in a form of black purple crystal.
$^1$H NMR (500 MHz, $CD_2Cl_2$) : 1.37 (s, 18H), 7.16 (d, J=9.0Hz, 2H), 7.48-7.56 (m, 4H), 7.67 (dd, J=2.6, 9.0Hz, 2H), 7.92 (dt, J=9.5, 3.2Hz, 2H), 8.35 (s, 2H), 9.05 (s, 2H).

Reference Example 15

Preparation of exemplary compound (1-88): [2,2'-(2,2'-bipyridine)-6,6'-diyl-bis[phenolate]]-N,N',O,O']platinum (II)

[(1,2,5,6-$\eta^4$)-1,5-hexadienyl]platinum (II) dichloride (100 mg, 0.287 mmol, 1.0 equivalent), the exemplary compound (2-88) prepared in Reference Example 8-3 (108 mg, 0.316 mmol, 1.1 equivalents) and potassium hydroxide (40 mg, 0.718 mmol, 2.5 equivalents) were placed in a Schlenk flask and the internal gas was substituted with nitrogen. Then, 2-ethoxyethanol (10 mL) was added thereto, and the mixture was stirred under reflux for 1 hour. Crystals were filtered from the brown suspension obtained and washed with hexane. The crude crystal was purified by silica gel column

chromatography (eluent: methylene chloride/methanol: 20/1) and recrystallized from hexane/dichloromethane, to give 119 mg of the exemplary compound (1-88) in a form of red orange-colored powder. Yield: 77.7%.
$^1$H NMR (500 MHz, $CD_2Cl_2$): 6.80 (ddd, J=1.1, 6.7, 8.1Hz, 2H), 7.29 (br d, J=8.5Hz, 2H), 7.39 (ddd, J=1.7, 6.7, 8.3Hz, 2H), 7.92 (br d, J=7. 9Hz, 2H), 8.00 (br d, J=8.3Hz, 2H), 8.08-8.15 (m, 2H), and 8.20-8.25 (m, 2H).

Example 1

An organic EL device having the layer structure shown in Fig. 1 was prepared by forming, on a glass substrate (g), an anode (f), a hole transporting layer (e), a light-emitting layer (d) consisting of a host material and a dopant material, a hole blocking layer (c), an electron transporting layer (b) and a cathode (a) in that order from the glass substrate (g). In the organic EL device, the anode (f) and the cathode (a) have lead wires respectively connected, and a voltage can be applied between the anode (f) and the cathode (a) through the wires. Typical materials and production methods of each layer will be described in order below.

First, the anode (f) is made of an ITO film, and deposited on a glass substrate (g). The hole transporting layer (e) is formed to be 40 nm in thickness on the anode (f) by vacuum deposition of the compound (α-NPD) represented by the following Formula:

(α-NPD)

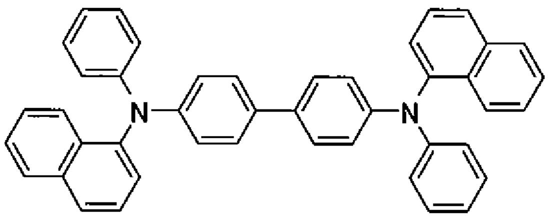

The light-emitting layer (d) containing a host material and a doped phosphorescence light-emitting material is formed to be 35 nm in thickness on the hole transporting layer (e) by simultaneous vacuum deposition (dope 3%) of the compound CBP represented by the following Formula:

(CBP)

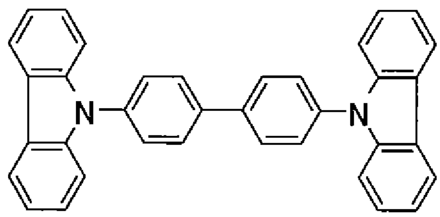

and the compound (1-11) prepared in Reference Example 9 and represented by the following Formula:

(1-11)

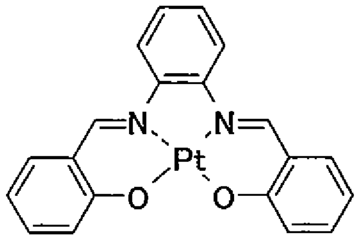

In addition, the hole blocking layer (c) is formed to be 10 nm in thickness on the light-emitting layer (d) by vacuum deposition of the compound (BCP) represented by the following Formula:

(BCP)

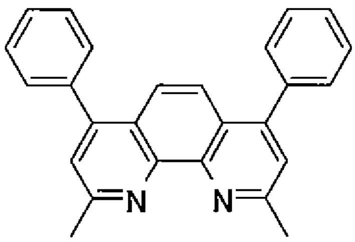

The electron transporting layer (b) is formed to be 35 nm in thickness on the hole blocking layer (c) by vacuum deposition of the compound $Alq_3$ represented by the following Formula:

($Alq_3$)

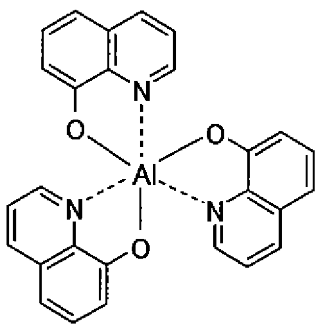

The cathode (a) is formed as a deposited film by vacuum co-deposition of Mg and Ag at a ratio of 10:1 to be 100 nm in thickness and then vacuum deposition of Ag additionally to be 10 nm in thickness in that order from the side of the electron transporting layer (b).

When a plus voltage is applied to the anode (ITO) (f) of the organic EL device obtained and a minus voltage to the cathode (a), stabilized light emission was confirmed even at a very low voltage. The external quantum efficiency of the device showed extremely high value of 5.0% at a brightness of 100 cd/$m^2$. Also observed was emission of red light extremely high in color purity derived from the compound (1-11) used in the light-emitting layer (d).

The characteristics of the organic EL device prepared in Example 1 above are summarized in the following Table 1.

Table 1: Characteristics of the device prepared

| Ex. No. | Emitting layer | EL peak (nm) | CIE Chromaticity point at 100 $cd/m^2$ | External quantum efficiency at 100 $cd/m^2$ (%) | Power Efficiency at 100 $cd/m^2$ (1m/W) |
|---|---|---|---|---|---|
| 1 | 1-11(3%), CBP | 627.4 | 0.64, 0.35 | 4.9 | 1.7 |

Example 2

A device having a structure similar to that of the device of Example 1 was prepared by using, as a platinum complex, the platinum complex (1-15) represented by the following formula:

(1−15)

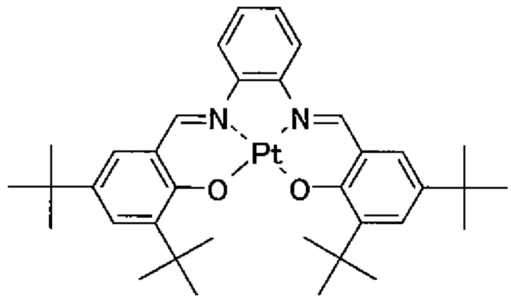

instead of the platinum complex (1-11) in the light-emitting layer. The characteristics of the organic EL device are summarized in the following Table 2.

Table 2: Characteristics of the device prepared

| Ex. No. | Emitting layer | EL peak (nm) | CIE Chromaticity point at 100 $cd/m^2$ | External quantum efficiency at 100 $cd/m^2$ (%) | Power Efficiency at 100 $cd/m^2$ (1m/W) |
|---|---|---|---|---|---|
| 2 | 1-15(3%), CBP | 647.1 | 0.67, 0.30 | 5.0 | 1.0 |

Comparative Example 1

A device having a structure similar to that of the devices of Examples 1 and 2 was prepared by using a known red phosphorescent material, (2,3,7,8,12,13,17,18-octaethyl-21H,23H-porphinato-N,N,N,N)platinum (II) (Pt (OEP)) that is superior in performance and represented by the following Formula:

(Pt(OEP))

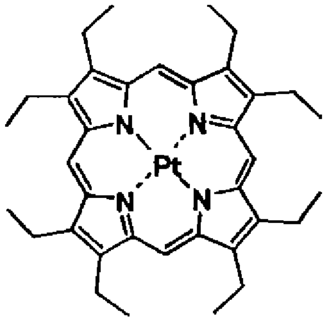

instead of the platinum complexes (1-11) and (1-15) as a platinum complex in the light-emitting layer (d). The characteristics of the organic EL device are summarized in Table 3.

Table 3: Characteristics of the device prepared

| Com. Ex. No. | Emitting layer | EL peak (nm) | CIE Chromaticity Point at 100 cd/$m^2$ | External quantum efficiency at 100 cd/$m^2$ (%) | Power Efficiency at 100 cd/$m^2$ (1m/W) |
|---|---|---|---|---|---|
| 1 | Pt (OEP) (3%), CBP | 648 | 0.72, 0.27 | 2.6 | 0.3 |

Comparison between the characteristics of the organic EL devices prepared in Examples 1, Example 2 and Comparative Example 1 reveals that these devices emit red light higher in color purity. On the other hand, as for the efficiency of device, the device of Example 1 has an external quantum efficiency higher by 1.88 times and a power efficiency higher by 5.67 times than those of the device of Comparative Example 1. Further, the device of Example 2 has an external quantum efficiency higher by 1.92 times and a power efficiency higher by 3.33 times than those of the device of Comparative Example 1. As apparent from these results, the organic EL device containing the platinum complex (1) of the invention is extremely superior in color purity, external quantum efficiency and power efficiency.

ADVANTAGEOUS EFFECTS OF THE INVENTION

The light-emitting device containing a platinum complex of the present invention is extremely superior in color purity, external quantum efficiency and power efficiency and various display devices, especially high-efficiency organic EL devices are obtained by the invention.

## Claims

**1.** A light-emitting device containing one or more of platinum complexes represented by general formula (1):

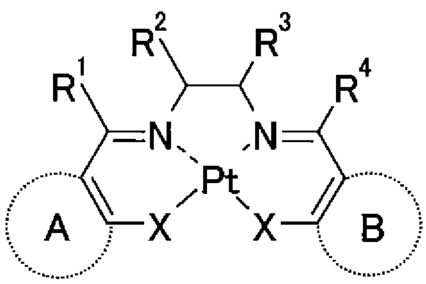

wherein, rings A and B each independently represent an aromatic ring optionally having substituent (s) or an aromatic heterocyclic ring optionally having substituent (s) ; X represents an oxygen atom or a sulfur atom; $R^1$, $R^2$, $R^3$and $R^4$ each independently represent a hydrogen atom or a substituent; and more $R^1$ and $R^2$, $R^2$ and $R^3$, and $R^3$ and $R^4$ may respectively combine together to form a fused ring.

**2.** The light-emitting device as claimed in claim 1, wherein the light-emitting device has a light-emitting layer or organic compound-containing multiple layers including an light-emitting layer between a pair of electrodes and contains one or more of the platinum complex(es) (1) in at least one of the layers.

**3.** The light-emitting device as claimed in claim 2, wherein the light-emitting device is an organic electroluminescent device (organic EL device).

**4.** The light-emitting device as claimed in claim 2 or 3, wherein the platinum complex contained in at least one layer of the light-emitting device can act as a dopant material in the light-emitting layer.

Fig. 1

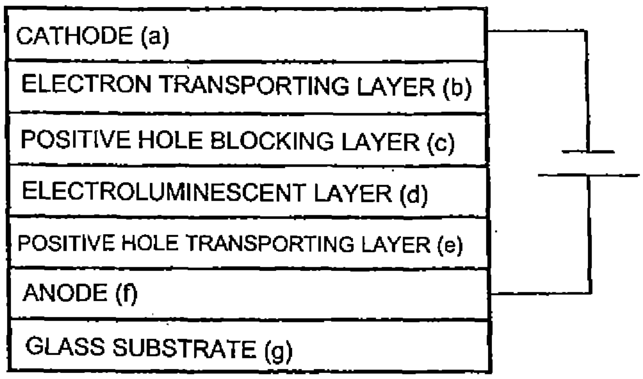
CATHODE (a)
ELECTRON TRANSPORTING LAYER (b)
POSITIVE HOLE BLOCKING LAYER (c)
ELECTROLUMINESCENT LAYER (d)
POSITIVE HOLE TRANSPORTING LAYER (e)
ANODE (f)
GLASS SUBSTRATE (g)

**INTERNATIONAL SEARCH REPORT**

International application No.
PCT/JP2004/005941

A. CLASSIFICATION OF SUBJECT MATTER
Int.Cl[7] C09K11/06, H05B33/14

According to International Patent Classification (IPC) or to both national classification and IPC

B. FIELDS SEARCHED

Minimum documentation searched (classification system followed by classification symbols)
Int.Cl[7] C09K11/06, H05B33/14

Documentation searched other than minimum documentation to the extent that such documents are included in the fields searched

Electronic data base consulted during the international search (name of data base and, where practicable, search terms used)
CA(STN), REGISTRY(STN)

C. DOCUMENTS CONSIDERED TO BE RELEVANT

| Category* | Citation of document, with indication, where appropriate, of the relevant passages | Relevant to claim No. |
|---|---|---|
| X | WO 02/31896 A2 (E.I. DU PONT DE NEWMOURS AND CO.), 18 April, 2002 (18.04.02), & EP 1364419 A2 | 1-4 |
| X | JP 5-9470 A (Pioneer Electronic Corp.), 19 January, 1993 (19.01.93), Claims; Par. Nos. [0010] to [0018], [0033] (Family: none) | 1-4 |
| X | JP 10-67984 A (Futaba Corp.), 10 March, 1998 (10.03.98), Claims 7, 8 & US 6410166 B1 | 1-4 |

[X] Further documents are listed in the continuation of Box C.  [ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 03 August, 2004 (03.08.04) | 24 August, 2004 (24.08.04) |
| Name and mailing address of the ISA/ Japanese Patent Office | Authorized officer |
| Facsimile No. | Telephone No. |

Form PCT/ISA/210 (second sheet) (January 2004)

**INTERNATIONAL SEARCH REPORT**

International application No.
PCT/JP2004/005941

C (Continuation). DOCUMENTS CONSIDERED TO BE RELEVANT

| Category* | Citation of document, with indication, where appropriate, of the relevant passages | Relevant to claim No. |
|---|---|---|
| X | JP 2003-123981 A (Canon Inc.), 25 April, 2003 (25.04.03), Claims; Par. Nos. [0093], [0069] (Family: none) | 1-4 |
| X | JP 2003-123980 A (Canon Inc.), 25 April, 2003 (25.04.03), Claims; Par. No. [0050] (Family: none) | 1-4 |
| A | JP 2000-48960 A (Bayer AG.), 18 February, 2000 (18.02.00), & EP 969532 A2 & DE 19829948 B | 1-4 |
| A | JP 2001-3043 A (Mitsumi Electric Co., Ltd.), 09 January, 2001 (09.01.01), Claim 1 (Family: none) | 1-4 |

Form PCT/ISA/210 (continuation of second sheet) (January 2004)